# EUROPÄISCHE PATENTSCHRIFT

(11) **EP 4 377 122 B1**
(45) Veröffentlichungstag und Bekanntmachung des Hinweises auf die Patenterteilung: **01.01.2025**
(21) Anmeldenummer: 22757273.2
(22) Anmeldetag: 26.07.2022
(51) Int. Cl.: B60L 3/00, G01R 31/00, G01R 31/12, H02J 7/00, H02H 3/26, G01R 31/36, H02H 3/02, H02H 3/44, H02H 5/12

(54) **SCHUTZVORRICHTUNG FÜR EIN ELEKTRISCHES GLEICHSTROMNETZ, BORDNETZ FÜR EIN FAHRZEUG, FAHRZEUG UND GLEICHSTROMLADESTATION**
SAFETY DEVICE FOR AN ELECTRIC DC GRID, ON-BOARD ELECTRICAL SYSTEM FOR A VEHICLE, VEHICLE, AND DC CHARGING STATION
DISPOSITIF DE SÉCURITÉ POUR UN RÉSEAU ÉLECTRIQUE À COURANT CONTINU, SYSTÈME ÉLECTRIQUE EMBARQUÉ POUR UN VÉHICULE, VÉHICULE ET BORNE DE RECHARGE À COURANT CONTINU

(30) Priorität: 27.07.2021 DE 102021003830
(43) Veröffentlichungstag der Anmeldung: 05.06.2024
(73) Patentinhaber: Mercedes-Benz Group AG, 70372 Stuttgart (DE)
(72) Erfinder: BOEHME, Urs, 71139 Ehningen (DE)
(74) Vertreter: Novagraaf Group
(86) Internationale Anmeldenummer: PCT/EP2022/070890
(87) Internationale Veröffentlichungsnummer: WO 2023/006715

(56) Entgegenhaltungen:
- DE-A1- 102019 008 833
- DE-A1- 4 327 484

## Beschreibung

Die Erfindung betrifft eine Schutzvorrichtung für ein elektrisches Gleichstromnetz nach den Merkmalen des Oberbegriffs des Anspruchs 1, ein Bordnetz für ein Fahrzeug, ein Fahrzeug und eine Gleichstromladestation.

Aus dem Stand der Technik beschreibt die gattungsbildende Schrift DE 10 2019 202 892 A1 eine Bordnetzanordnung für ein Kraftfahrzeug, wobei die Bordnetzanordnung einen Hochvolt-Energiespeicher zur Bereitstellung eines ersten Hochvolt-Potentials und eines zweiten Hochvolt-Potentials aufweist. Zwischen dem ersten und dem zweiten Hochvolt-Potential ist eine Gesamtspannung abgreifbar, wobei zwischen dem ersten Hochvolt-Potential und einer vorbestimmten elektrischen Masse ein erster Isolationswiderstand besteht und zwischen dem zweiten Hochvolt-Potential und der vorbestimmten elektrischen Masse ein zweiter Isolationswiderstand besteht. Eine Isolationsüberwachungseinrichtung überwacht den ersten und zweiten Isolationswiderstand und weist dabei eine Ausgleichsschaltung auf, die dazu ausgelegt ist, einen aktiven Symmetriervorgang durchzuführen, so dass durch den aktiven Symmetriervorgang ein Unterschied zwischen dem ersten Isolationswiderstand und dem zweiten Isolationswiderstand zumindest reduziert wird.

Auch die DE 10 2018 211 625 A1 offenbart eine Bordnetzanordnung für ein Kraftfahrzeug mit einem Hochvolt-Energiespeicher zur Bereitstellung eines ersten und eines zweiten Hochvolt-Potentials zwischen welchen eine Gesamtspannung abgreifbar ist. Die Bordnetzanordnung ist derart symmetrisch ausgebildet, dass ein erster Isolationswiderstand, zwischen dem ersten Hochvolt-Potential und einer Masse, und ein zweiter Isolationswiderstand, zwischen dem zweiten Hochvolt-Potential und der Masse, sich maximal um ein vorbestimmbares Maß unterscheidet. Hierzu weist die Bordnetzanordnung eine Symmetrieüberwachungseinrichtung auf, die zur Überwachung der Bordnetzsymmetrie ausgelegt ist und vorbestimmte Maßnahme auslöst, falls sich der erste Isolationswiderstand vom zweiten Isolationswiderstand um mehr als das vorbestimmbare Maß unterscheidet.

Aus dem Stand der Technik ist, wie in der DE 10 2017 009 355 A1 beschrieben, ebenso auch ein Verfahren zum Betreiben von elektrischen Bordnetzen bekannt. In dem Verfahren zum Betreiben eines mit einer ersten elektrischen Gleichspannung beaufschlagten ersten Bordnetzes und eines mit einer zweiten elektrischen Gleichspannung beaufschlagten zweiten Bordnetzes werden das erste und das zweite Bordnetz mittels eines einen ersten getakteten Energiewandler aufweisenden Energiekopplers elektrisch gekoppelt. Die erste und die zweite elektrische Gleichspannung sind mittels einer elektrischen Isolationseinrichtung gegenüber einem elektrischen Bezugspotential elektrisch isoliert. Die elektrische Isolationseinrichtung wird überwacht. Das erste und das zweite Bordnetz werden mittels des Energiekopplers galvanisch gekoppelt. Bei einer Störung der Isolationseinrichtung in einem Bereich eines der beiden Bordnetze steuert der Energiekoppler elektrische Potentiale des jeweiligen anderen der beiden Bordnetze derart, dass jeweilige Potentialdifferenzen von diesen elektrischen Potentialen zum Bezugspotential kleiner als ein vorgegebener Vergleichswert sind.

In der DE 10 2019 008 833 werden eine Schutzvorrichtung für ein elektrisches Gleichstromnetz, insbesondere für ein Hochvoltnetz, ein Bordnetz für ein Fahrzeug, ein Fahrzeug und eine Gleichstromladestation beschrieben. Die Schutzvorrichtung umfasst entweder eine erste Spannungsmessvorrichtung zwischen einer Pluspotentialleitung und einer Bezugspotentialleitung zur Messung einer Spannung zwischen der Pluspotentialleitung und der Bezugspotentialleitung und eine zweite Spannungsmessvorrichtung zwischen einer Minuspotentialleitung und der Bezugspotentialleitung zur Messung einer Spannung zwischen der Minuspotentialleitung und der Bezugspotentialleitung, oder eine Fehlerstrommessvorrichtung in der Bezugspotentialleitung. Die Schutzvorrichtung umfasst des Weiteren eine Schutzschaltung, entweder mit einer elektrischen Reihenschaltung eines Entladewiderstands und eines ersten Schutzschalters zwischen der Pluspotentialleitung und der Bezugspotentialleitung und einer elektrischen Reihenschaltung des Entladewiderstands und eines zweiten Schutzschalters zwischen der Minuspotentialleitung und der Bezugspotentialleitung, oder mit zwei Schutzschaltungsteilen, wobei der erste Schutzschaltungsteil eine elektrische Reihenschaltung eines ersten Entladewiderstands und eines ersten Schutzschalters zwischen der Pluspotentialleitung und der Bezugspotentialleitung umfasst und der zweite Schutzschaltungsteil eine elektrische Reihenschaltung eines zweiten Entladewiderstands und eines zweiten Schutzschalters zwischen der Minuspotentialleitung und der Bezugspotentialleitung umfasst. Der erste Schutzschalter ist bei einem mittels der ersten und/oder zweiten Spannungsmessvorrichtung ermittelten Unterschreiten eines vorgegebenen Spannungswertes zum Schließen ansteuerbar und der zweite Schutzschalter ist bei einem mittels der zweiten und/oder ersten Spannungsmessvorrichtung ermittelten Unterschreiten des vorgegebenen Spannungswertes zum Schließen ansteuerbar. Alternativ sind/ist der erste Schutzschalter und/oder der zweite Schutzschalter bei einem mittels der Fehlerstrommessvorrichtung gemessenen Fehlerstrom zum Schließen ansteuerbar.

Der Erfindung liegt die Aufgabe zu Grunde, eine gegenüber dem Stand der Technik verbesserte Schutzvorrichtung für ein elektrisches Gleichstromnetz, ein gegenüber dem Stand der Technik verbessertes Bordnetz für ein Fahrzeug, ein gegenüber dem Stand der Technik verbessertes Fahrzeug mit einem solchen Bordnetz und eine gegenüber dem Stand der Technik verbesserte Gleichstromladestation anzugeben.

Die Aufgabe wird erfindungsgemäß gelöst durch eine Schutzvorrichtung für ein elektrisches Gleichstromnetz mit den Merkmalen des Anspruchs 1, ein Bordnetz für ein Fahrzeug mit den Merkmalen des Anspruchs 5, ein Fahrzeug mit den Merkmalen des Anspruchs 6 und eine Gleichstromladestation mit den Merkmalen des Anspruchs 7.

Vorteilhafte Ausgestaltungen der Erfindung sind Gegenstand der Unteransprüche.

Eine erfindungsgemäße Schutzvorrichtung für ein elektrisches Gleichstromnetz, insbesondere für ein Hochvoltnetz, beispielsweise für ein Bordnetz eines Fahrzeugs, umfasst eine erste Spannungsmessvorrichtung zwischen einer Pluspotentialleitung und einer Bezugspotentialleitung zur Messung einer Spannung zwischen der Pluspotentialleitung und der Bezugspotentialleitung und eine zweite Spannungsmessvorrichtung zwischen einer Minuspotentialleitung und der Bezugspotentialleitung zur Messung einer Spannung zwischen der Minuspotentialleitung und der Bezugspotentialleitung. Das Bezugspotential ist insbesondere ein elektrisches Massepotential, bei Verwendung der Schutzvorrichtung in einem Fahrzeug, insbesondere ein Fahrzeugmassepotential, bei Verwendung der Schutzvorrichtung in einer Gleichstromladestation, beispielsweise ein Erdpotential.

Des Weiteren umfasst die Schutzvorrichtung eine Schutzschaltung zur Reduzierung eines durch Y-Kondensatoren des elektrischen Gleichstromnetzes verursachten elektrischen Schlags, insbesondere einer Person, d. h. eines menschlichen Körpers.

Die Schutzschaltung umfasst einen ersten Schutzschalter zwischen der Pluspotentialleitung und der Bezugspotentialleitung und einen zweiten Schutzschalter zwischen der Minuspotentialleitung und der Bezugspotentialleitung. Es sind mehrere Auslösekriterien vorgegeben, wobei der erste Schutzschalter und/oder der zweite Schutzschalter ausschließlich bei einem mittels der ersten Spannungsmessvorrichtung und/oder mittels der zweiten Spannungsmessvorrichtung ermittelten Eintritt aller vorgegebenen Auslösekriterien zum Schließen ansteuerbar sind/ist. Die Auslösekriterien betreffen insbesondere Fehlerursachen/Störungen, die auftreten können und bei deren Auftreten das Schließen der Schutzschalter verhindert werden soll. Vorteilhafterweise ist für jede dieser Fehlerursachen/Störungen mindestens ein Auslösekriterium derart vorgegeben, dass es bei Körperkontakt, d. h. bei Kontakt einer Person, d. h. eines menschlichen Körpers, mit einem der Hochvoltpotentiale, eintritt und bei Auftreten der jeweiligen Fehlerursache nicht eintritt. Die Auslösung, d. h. das Schließen des jeweiligen Schutzschalters, erfolgt nur, wenn alle vorgegebenen Auslösekriterien eintreten, d. h. erfüllt sind. Dadurch wird sichergestellt, dass der jeweilige Schutzschalter nur bei Körperkontakt, d. h. bei Kontakt einer Person, d. h. eines menschlichen Körpers, mit einem der Hochvoltpotentiale geschlossen wird und ein fehlerhaftes Schließen aufgrund des Auftretens einer oder mehrerer der Fehlerurachen/Störungen sicher vermieden wird.

Ein erfindungsgemäßes elektrisches Bordnetz, insbesondere Hochvoltbordnetz, für ein Fahrzeug, insbesondere für ein Elektrofahrzeug oder Hybridfahrzeug, umfasst eine solche Schutzvorrichtung.

Ein erfindungsgemäßes Fahrzeug, insbesondere Elektrofahrzeug oder Hybridfahrzeug, umfasst eine solche Schutzvorrichtung, insbesondere ein solches elektrisches Bordnetz, insbesondere Hochvoltbordnetz, mit einer solchen Schutzvorrichtung.

Eine erfindungsgemäße, insbesondere fahrzeugexterne, Gleichstromladestation, insbesondere Hochvoltgleichstromladestation, insbesondere zum elektrischen Laden eines Fahrzeugs, insbesondere eines Elektrofahrzeugs oder Hybridfahrzeugs, insbesondere einer Hochvoltbatterie eines solchen Fahrzeugs, umfasst eine solche Schutzvorrichtung.

Unter dem Begriff "Hochvolt" ist insbesondere eine elektrische Gleichspannung zu verstehen, die insbesondere größer als etwa 60 V ist. Insbesondere ist der Begriff "Hochvolt" konform zur Norm ECE R 100 auszulegen.

Durch die erfindungsgemäße Lösung wird vorteilhafterweise erreicht, dass die Schutzschaltung sowohl sehr schnell auslöst, um eine im Körperwiderstand umgesetzte Ladung und Energie gering zu halten, als auch eine fehlerhafte Auslösung so wenig wie möglich erfolgt oder vorteilhafterweise vermieden wird. Eine Fehlauslösung würde für eine sehr kurze Zeitspanne zu einem Isolationsfehler führen. Zudem sorgt die Schutzschaltung für eine massive Verschiebung der Hochvoltpotentiale, was eine maximale Abweichung vom energetischen Minimum der in den Y-Kondensatoren gespeicherten Energie darstellt. Zudem kann bei einem wiederholten Fehlauslösen der Schutzschaltung die Funktion eines Isolationswächters beeinträchtigt werden. Beispielsweise können Störquellen im Fahrzeug und/oder in der Gleichstromladestation die Schutzschaltung zum fehlerhaften Auslösen veranlassen. Dies wird durch die erfindungsgemäße Lösung vermieden oder zumindest erheblich reduziert.

Durch die erfindungsgemäße Lösung wird die Auswertung der Schutzschaltung stabiler gegen Fehlauslösungen, indem mehrere Auslösekriterien gleichzeitig eintreten müssen. Die einzelnen Auslösekriterien werden insbesondere mit einer Und-Verknüpfung ausgewertet. Die einzelnen Auslösekriterien sind abhängig von der Art der Störung. Verglichen wird die Störungs-Form mit der Charakteristik einer Entladung der Y-Kondensatoren durch einen Körperwiderstand. Vorteilhafterweise wird zur Unterscheidung jeglicher Störung von einer solchen CY-Körperwiderstandsentladung mindestens ein Merkmal gefunden, welches durch eine Messung oder Auswertung erfasst werden kann. Jeweils mindestens dieses eine Merkmal pro Störung muss sich von der Eigenschaft der CY-Körperstromentladung unterscheiden. Beispielhaft sind dies die Unterscheidung zwischen Common-Mode und Differential-Mode-Ereignissen, Mindest-Umladespannungen, Zeitkonstanten einer Kondensator-Umladung (Zeitkonstante der e-Funktion), Frequenzen/ Frequenzspektren oder Wiederholraten einer taktenden Störung usw. Als Mess-Eingangsgröße wird die Spannungsmessung mittels der Spannungsmessvorrichtungen verwendet, d. h. zwischen Pluspotentialleitung und Bezugspotentialleitung und zwischen Minuspotentialleitung und Bezugspotentialleitung.

Durch die Verknüpfung der Auslösung der Schutzschaltung an verschiedene charakteristische Merkmale einer CY-Körperentladung kann erreicht werden, dass die Anzahl der Fehlauslösungen minimiert oder komplett vermieden wird. Gleichzeitig wird eine sehr schnelle Auslösezeit erreicht und somit die im menschlichen Körper umgesetzte Energie/Ladung minimiert.

Die mittels der Spannungsmessvorrichtungen gemessenen Spannungen werden insbesondere wie folgt ausgewertet:
- Ermittlung von Abweichungen aktuell anliegenden Spannungen dU von Pluspotentialleitung zu Bezugspotentialleitung und von Minuspotentialleitung zu Bezugspotentialleitung bezogen auf einen zeitlich zuvor ermittelten Spannungswert, und/oder
- Ermittlung von Spannungsänderungen dU/dt, d. h. über die Zeit, der Spannungen von Pluspotentialleitung zu Bezugspotentialleitung und von Minuspotentialleitung zu Bezugspotentialleitung, und/oder
- Beachtung des entgegengesetzten Vorzeichens, insbesondere bei den obigen beiden Ermittlungen, bezüglich der Auswertung der Spannungen von Pluspotentialleitung zu Bezugspotentialleitung und von Minuspotentialleitung zu Bezugspotentialleitung, und/oder
- Beachten einer zyklischen Wiederholung einer auftretenden Störung.

Die Auslösekriterien umfassen somit:
- die Spannungsabweichung der aktuell zwischen der Pluspotentialleitung und der Bezugspotentialleitung anliegenden Spannung und der zwischen der Minuspotentialleitung und der Bezugspotentialleitung anliegenden Spannung vom zeitlich zuvor ermittelten Spannungswert, und/oder
- die Spannungsänderungen über die Zeit der zwischen der Pluspotentialleitung und der Bezugspotentialleitung anliegenden Spannung und der zwischen der Minuspotentialleitung und der Bezugspotentialleitung anliegenden Spannung, und/oder
- das entgegengesetzte Vorzeichen der zwischen der Pluspotentialleitung und der Bezugspotentialleitung anliegenden Spannung und der zwischen der Minuspotentialleitung und der Bezugspotentialleitung anliegenden Spannung, und/oder
- ein Nichtvorliegen einer zyklischen Wiederholung der anderen Auslösekriterien.

Der erste Schutzschalter und/oder der zweite Schutzschalter sind/ist ausschließlich dann ansteuerbar, wenn
- die Spannungsabweichung der aktuell zwischen der Pluspotentialleitung und der Bezugspotentialleitung anliegenden Spannung und der zwischen der Minuspotentialleitung und der Bezugspotentialleitung anliegenden Spannung von dem zeitlich zuvor ermittelten Spannungswert einen vorgegebenen Grenzwert überschreitet, in einem möglichen Ausführungsbeispiel einen Grenzwert von 30 V, und
- die Spannungsänderungen über die Zeit der zwischen der Pluspotentialleitung und der Bezugspotentialleitung anliegenden Spannung und der zwischen der Minuspotentialleitung und der Bezugspotentialleitung anliegenden Spannung einen vorgegebenen Grenzwert überschreitet, und
- das entgegengesetzte Vorzeichen der zwischen der Pluspotentialleitung und der Bezugspotentialleitung anliegenden Spannung und der zwischen der Minuspotentialleitung und der Bezugspotentialleitung anliegenden Spannung vorliegt.

Die Grenzwerte sind insbesondere abhängig von der zu betrachtenden Zeitkonstante t = R*C. Hierbei ist R der Körperwiderstand des Menschen, der gemäß Normvorgaben bis 500 Ohm als niedrigster Wert angenommen wird. Beispielsweise werden Köperwiderstände im Bereich von 300 Ohm bis 30k Ohm berücksichtigt. C ist abhängig von der sich im Hochvoltsystem, d. h. im Hochvoltgleichstromnetz, befindlichen Gesamtkapazität der Y-Kondensatoren. Dies ist beispielsweise fahrzeugsituationsabhängig, zum Beispiel, ob nur das Fahrzeug betrachtet wird, beispielsweise während eines Fahrbetriebs, oder das Fahrzeug in Verbindung mit einer Gleichstromladestation. Beispielsweise wird für C ein Bereich von 200 nF (insbesondere nur Fahrzeug, insbesondere optimiert auf niedrige Kapazitäten der Y-Kondensatoren) bis zu einem Wert beim Megawatt-Laden, d. h. Gleichstromladen mit hohen Leistungen, von ca. 8 µF (Gleichstromladestation und Fahrzeug). Alle Kapazitätswerte beziehen sich pro Hochvoltpotential, d. h. als Gesamtkapazität ist der doppelte Wert anzunehmen. Die Schutzschaltung hat insbesondere die Anforderung, bei Spannungen oberhalb von 60 V aktiv zu sein. Als Abgrenzung werden beispielsweise zu niedrige Frequenzen der Isolationswächter gesehen (ca. 800 kOhm Prüfwiderstand, Taktzeit ca. 10 s) und zu den Frequenzen oberhalb der Auslösezeitkonstante ein Inverter mit einer Taktfrequenz von mind. 2 kHz betrachtet.

Erfindungsgemäß sind/ist der erste Schutzschalter und/oder der zweite Schutzschalter ausschließlich dann ansteuerbar, wenn zusätzlich das Nichtvorliegen einer zyklischen Wiederholung der anderen Auslösekriterien ermittelt ist.

Beispielsweise ist eine analoge und/oder digitale Auswertung der mittels der ersten Spannungsmessvorrichtung und/oder mittels der zweiten Spannungsmessvorrichtung ermittelten Spannung vorgesehen.

Beispielsweise sind bei der analogen Auswertung mit einem Ausgang der Spannungsmessung (z. B. hochohmiger Widerstandsteiler) je Hochvoltpotential zwei Auswertungen über Operationsverstärkerschaltungen verbunden. Die Operationsverstärkerschaltungen verfügen über zwei unterschiedliche Zeitkonstanten. Mit der Operationsverstärkerschaltung der ersten Zeitkonstante (niedrige Frequenz, unterhalb einer Zeitkonstante einer Entladung über einen menschlichen Körperwiderstand) wird die Spannungsabweichung vom zuvor ermittelten Spannungswert ermittelt. Mit der Operationsverstärkerschaltung der zweiten Zeitkonstante (höhere Frequenz, oberhalb der Zeitkonstante der Entladung über einen menschlichen Körperwiderstand) wird die Spannungsänderung über die Zeit ermittelt. Diese beiden Auslösekriterien sind in einer logischen Und-Verknüpfung verbunden und es wird zugleich eine logische Und-Verknüpfung mit dem negierten Ergebnis der Auswertung des jeweiligen anderen Hochvoltpotentials durchgeführt, um dadurch zu ermitteln, ob die beiden Spannungen entgegengesetzte Vorzeichen aufweisen. Ist das Gesamtergebnis "wahr", erfolgt eine Ansteuerung der Schutzschaltung.

Bei der digitalen Auswertung werden die gemessenen Spannungen beispielsweise von einem Mikrocontroller, Asic (anwendungsspezifische integrierte Schaltung) oder FPGA (Field Programmable Gate Array, d. h. ein integrierter Schaltkreis der Digitaltechnik, in welchen eine logische Schaltung geladen werden kann) erfasst. Es erfolgt softwarebasierend die Filterung und Ermittlung der Spannungsabweichung vom zuvor ermittelten Spannungswert und der Spannungsänderung über die Zeit je Hochvoltpotential und anschließend die für die analoge Auswertung bereits beschriebenen Und-Verknüpfungen. Ist das Gesamtergebnis "wahr" erfolgt eine Ansteuerung der Schutzschaltung.

Beispielsweise werden die analoge und digitale Auswertung gleichzeitig umgesetzt, insbesondere als Redundanz.

Durch die beschriebene Lösung wird erreicht, dass möglichst schnell eine Berührung eines Hochvoltpotentials durch einen menschlichen Körper erkannt wird und die Zuschaltung der Schutzschaltung durchgeführt wird. Die schnelle Zuschaltung begründet sich durch den relativ schnell ablaufenden Entladevorgang/Umladevorgang der Y-Kondensatoren während der Berührung eines Hochvoltpotentials durch den menschlichen Körper (Größenordnung ca. 10 ms). Hierbei tritt der größte Teil der im Körper umgesetzten Energie oder der durch den Körper durströmten Ladung zu Beginn des Entlade-/Umladevorgangs auf. Er schwächt sich auf einer e-Funktion ab. Dies macht es zudem erforderlich, möglichst schnell die Schutzschaltung zur Auslösung zu bringen.

Es ist jedoch auch erforderlich, dass Fehlauslösungen aufgrund anderer Einflussfaktoren ausgeschlossen sind oder zumindest nur selten auftreten. Eine fälschlicherweise ausgelöste Schutzschaltung führt zu einer energetisch sehr ungünstigen Potentialverteilung vom jeweiligen Hochvoltpotential zum Bezugspotential, wodurch der in den Y-Kondensatoren gespeicherte Energiebetrag in die Nähe seines maximalen Werts kommt, zum Beispiel Pluspotential zu Bezugspotential ungefähr 0 V und Bezugspotential zu Minuspotential ungefähr nahe einer Systemspannung des Hochvoltsystems, beispielsweise 800 V. Zudem wird bei der fälschlicherweise ausgelösten Schutzschaltung für den Moment der Aktivierung der Schutzschaltung ein Isolationsfehler erzeugt. Beim Zuschalten mittels einer Kapazität der Schutzschaltung wird zudem eine zusätzliche Kapazität zu den Y-Kondensatoren parallel geschaltet, was grundsätzlich die Möglichkeit bietet, in der nun vergrößerten Y-Gesamtkapazität mehr Energie zu speichern.

Da die Schutzschaltung möglichst schnell die Entladung durch den menschlichen Körperwiderstand erkennen muss, ist es notwendig, sie bezüglich des Reaktionsverhaltens schnell zu gestalten. Somit wird sie auch empfindlich gegenüber anderen Störeinflüssen. Durch die beschriebene Lösung werden Fehlauslösungen, welche durch diese höhere Empfindlichkeit verursacht werden könnten, vermieden oder zumindest erheblich reduziert. Mittel zur Unterscheidung zwischen Störung und Kontakt mit einem menschlichen Körperwiderstand bieten, wie oben bereits beschrieben, beispielsweise der Vergleich der Vorzeichen der beiden gemessenen Spannungen, wodurch eine Unterscheidung zwischen Common-Mode Störung und Differential-Mode Störung ermöglicht wird, Filter zur Unterscheidung von Störfrequenzen, eine Mittelwertbildung oder Spannungsänderung im Vergleich zu einem Mittelwert über einen definierten Zeitraum, insbesondere zur Unterscheidung von kleinen energetischen Einflüssen, ein maximaler Spannungshub der Umladevorgänge, und/oder Abtastvorgänge nach vorgegebenen Wiederholraten, zum Beispiel zum Erkennen von regelmäßig pulsierenden Störern, beispielsweise Invertern.

Betrachtet man den Umladevorgang der Y-Kondensatoren bei einer Berührung durch einen menschlichen Körper, so entspricht dies einer Gleichtakt-Störung bzw. einer Auslösung von Gleichtaktströmen. Dies wird vorteilhafterweise unterschieden von folgenden Einflüssen:
Eine Gleichtaktstörung, auch als Common-Mode-Störungen bezeichnet, einer taktenden Hochvoltkomponente würde ebenso wie bei einer Körperentladung einen gemeinsamen Strombeitrag über das Bezugspotential zur Folge haben. Der Frequenzbereich kann weit gestreut sein durch die Vielzahl von taktenden Hochvoltkomponenten im Fahrzeug, deren unterschiedlichen Taktfrequenzen und eventuell sogar variablen Taktfrequenzen, beispielsweise bei einem Bordlader mit einem isolierenden LLC-DC/DC-Wandler.

Taktende Hochvoltverbraucher sorgen neben den oben beschriebenen Common-Mode-Störungen zusätzlich für Differential-Mode-Störungen. Diese können mit ihrem Störpegel die Auswerteschaltung ebenfalls beeinflussen. Ein identisches Umladeverhalten wie bei einer Körper-Entladung der Y-Kondensatoren ruft auch ein Isolationswächter hervor. Hier ist bei den beiden bekannten Isolationswächter-Prinzipen vor allem der Isolationswächter mittels des Umladewiderstandes kritisch.

In der folgenden Tabelle ist ein Vergleich der CY-Körperentladung mit den oben beschriebenen Störeinflüssen hinsichtlich des Frequenzspektrums, des Spannungshubs, der Art der Störung (CM oder DM) und der Wiederholrate gegenübergestellt.

| Art des Fehlers/Störers | Frequenzbereich (Stör-)Spektrum | Spannungshub | EVM-Störung (Common Mode (CM) oder Differential Mode (DM)) | Wiederholrate |
|---|---|---|---|---|
| CY-Körperentladung | T = CY*R_Körper, ca. 2 kHz | Volle Umladung | CM | Einmalig oder langsam wiederkehrend |
| Taktender Verbraucher: Inverter, Taktungsstörung | 0 Hz - 1 MHz | <25 V | CM und DM | >10 kHz |
| Taktender Verbraucher: Inverter, Grundwelle | 0 Hz - 1 MHz | <25 V | CM und DM | 0-2 kHz |
| Taktender Verbraucher: DC/DC-Wandler | 0 Hz - 100 MHz | <25 V | CM und DM | >50 kHz |
| Taktender Verbraucher: Heizer | 0 Hz - 1 MHz | <25 V | CM und DM | ca. 50 Hz |
| Taktender Verbraucher: elektrischer Kältemittelverdichter | 0 Hz - 100MHz | <25 V | CM und DM | ca. 10 kHz |
| Isolationswächter | T=CY* 1 MOhm, ca. 1 Hz | Volle Umladung | CM | <1 Hz, wiederkehrend |
| Stromripple (Gleichstromlade n) | Ca. 5 - 100 kHz | 100 A*100 mOh m = 10 V | CM und DM | >100 kHz |

Der Lösungsansatz zur Vermeidung einer Fehlauslösung der Schutzschaltung liegt insbesondere darin, mehrere Merkmale miteinander zu verknüpfen.

Beispielsweise kann ein Bandpassfilter für die Spannungsmessung vorgesehen sein, welcher beispielsweise mittels Hardware oder Software realisiert werden kann. Dies ermöglicht eine Abgrenzung der Common Mode-Störungen des menschlichen Körperwiderstands von Störungen eines Isolationswächters, insbesondere nach unten, und von Common-Mode-Störungen von taktenden Komponenten, insbesondere nach oben. Dadurch wird eine Interaktion der Schutzschaltung mit dem Isolationswächter, Hochvoltverbrauchern und einer Ladestation (EVSE) reduziert.

Beispielsweise ist eine logische Verknüpfung der Spannungsauslösung für Pluspotential und Minuspotential vorgesehen. Dies ermöglicht eine sichere Unterscheidung von Common-Mode-Störungen und Differential-Mode-Störungen, so dass im Weiteren nur noch Common-Mode-Störungen betrachtet werden müssen. Dadurch wird eine Interaktion der Schutzschaltung mit taktenden Verbrauchern reduziert.

Beispielsweise wird ein Mindestumladehub, beispielsweise 50 V, berücksichtigt, d. h. die Schutzschaltung wird erst dann ausgelöst. Somit werden kleine Störungen ignoriert. Dadurch wird eine Interaktion der Schutzschaltung mit taktenden Verbrauchern reduziert.

Beispielsweise wird ein Moving Average, d. h. ein Mittelwert der Spannung über eine vorgegebene Zeitspanne, berücksichtigt, und erst bei dessen Erreichen die Schutzschaltung ausgelöst. Sehr niederohmige und regelmäßige Störungen werden dadurch schwächer bewertet. Dadurch wird eine Interaktion der Schutzschaltung mit taktenden Verbrauchern reduziert.

In einer möglichen Ausführungsform ist eine mit den Spannungsmessvorrichtungen und den Schutzschaltern gekoppelte gemeinsame Spannungsauswerteeinheit zur Auswertung der von der ersten Spannungsmessvorrichtung ermittelten Spannung und der von der zweiten Spannungsmessvorrichtung ermittelten Spannung und zur Ansteuerung des ersten Schutzschalters und/oder des zweiten Schutzschalters ausschließlich bei dem mittels der ersten Spannungsmessvorrichtung und/oder mittels der zweiten Spannungsmessvorrichtung ermittelten Eintritt aller vorgegebenen Auslösekriterien vorgesehen.

Der jeweilige Schutzschalter ist beispielsweise als ein Halbleiterschalter ausgebildet, zum Beispiel als ein MOSFET, IGBT oder Thyristor.

In einer möglichen Ausführungsform umfasst die Schutzschaltung beispielsweise eine elektrische Reihenschaltung eines Entladewiderstands und des ersten Schutzschalters zwischen der Pluspotentialleitung und der Bezugspotentialleitung und eine elektrische Reihenschaltung des Entladewiderstands und des zweiten Schutzschalters zwischen der Minuspotentialleitung und der Bezugspotentialleitung. Alternativ umfasst die Schutzschaltung beispielsweise zwei Schutzschaltungsteile, wobei der erste Schutzschaltungsteil eine elektrische Reihenschaltung eines ersten Entladewiderstands und des ersten Schutzschalters zwischen der Pluspotentialleitung und der Bezugspotentialleitung umfasst und der zweite Schutzschaltungsteil eine elektrische Reihenschaltung eines zweiten Entladewiderstands und des zweiten Schutzschalters zwischen der Minuspotentialleitung und der Bezugspotentialleitung umfasst.

Die beschriebene Lösung löst die mit Y-Kondensatoren in Fahrzeugen, insbesondere in Elektrofahrzeugen und Hybridfahrzeugen, und in Gleichstromladestationen verbundenen Probleme, wie im Folgenden erläutert wird. Solche Y-Kondensatoren werden als Maßnahmen verwendet, um Emission von EMV-Störungen zu reduzieren (EMV = elektromagnetische Verträglichkeit). Allerdings stellen sie ein erhöhtes Gefährdungspotential aus Hochvoltsicherheitsgründen dar. Beispielsweise wird in der Norm SAE J1772, IEC60479-1 und -2 eine enthaltene Ladungsmenge in den Y-Kondensatoren als gesundheitsgefährdendes Merkmal genannt (C1-Kennlinie). Mit zunehmender Betriebsspannung des Fahrzeugs wird es immer schwieriger, geforderte Grenzwerte dieser Normen einzuhalten. Teilweise sind auch alternative Maßnahmen, so genannte alternative Measures, zur Einhaltung von Sicherheitsvorgaben, beispielsweise eine verstärkte, insbesondere doppelte, elektrische Isolation, nicht zugelassen. Die weitere Norm LV123 und damit verbundene Normen schreiben beispielsweise einen maximalen Energieinhalt von 0,2 J für die Ladungsmenge aller Y-Kondensatoren vor. Wenn der Ausweg über die alternativen Maßnahmen erlaubt ist, dann kann beispielsweise die bereits erwähnte verstärkte, insbesondere doppelte, elektrische Isolation verwendet werden. Dies ist jedoch nur umsetzbar, wenn alle Hochvoltsysteme, die miteinander gekoppelt werden, entsprechend verstärkt isoliert sind. D. h., dass beispielsweise beim Gleichstromladen sowohl das Fahrzeug als auch die Gleichstromladestation, insbesondere Ladesäule, entsprechend verstärkt isoliert sein müssen. Da hierfür jedoch kein zwingender Standard existiert, wären auch Kopplungen von Systemen mit unterschiedlichen Isolationsauslegungen möglich, wodurch die Sicherheitsanforderungen nicht eingehalten werden.

Dieses Problem wird durch die beschriebene Schaltung gelöst, denn durch eine Spannungsmessung je Hochvoltpotential zum Bezugspotential, insbesondere Massepotential, wird eine Verschiebung der Hochvoltpotentiale, bezogen auf das Bezugspotential, erkannt, der die Folge eines Körperstroms sein kann, d. h. die Folge eines, insbesondere menschlichen, Körperkontakts mit einem der Hochvoltpotentiale und mit dem Bezugspotential. Um beim betroffenen Hochvoltpotential, bei welchem sich die Spannung zum Bezugspotential reduziert, die Spannung so schnell wie möglich zu reduzieren, wird der Entladewiderstand und vorteilhafterweise elektrisch parallel dazu ein ungeladener Schutzkondensator hinzugeschaltet. Die Spannung zwischen dem betroffenen Hochvoltpotential zum Bezugspotential springt dadurch schlagartig auf ein wesentlich niedrigeres Niveau, wodurch sich der Körperstrom proportional zur Spannung reduziert. Die beschriebene Lösung ermöglicht somit eine Reduzierung eines durch die Y-Kondensatoren verursachten elektrischen Schlags für den, insbesondere menschlichen, Körper. Eine Einhaltung der oben beschriebenen Anforderungen wird somit ermöglicht. Ebenfalls ist es möglich, die durch den Körperwiderstand umgesetzte elektrische Energie der Y-Kondensatoren auf ein Maß unterhalb von 0,2 J zu begrenzen, obwohl die in den Y-Kondensatoren gespeicherte Energie wesentlich höher sein kann.

Zum Entladewiderstand ist vorteilhafterweise, wie oben bereits erwähnt, ein Schutzkondensator elektrisch parallel geschaltet. Der Entladewiderstand allein müsste sehr niederohmig sein, um den Körperstrom schnell zu reduzieren. Nachteilig ist jedoch, dass damit ein niederohmiger Isolationsfehler erzeugt wird. Daher ist die Kombination aus Entladewiderstand und elektrisch parallel geschaltetem Schutzkondensator wesentlich vorteilhafter. Der Entladewiderstand stellt sicher, dass der elektrisch parallel geschaltete Schutzkondensator im Moment des Zuschaltens spannungsfrei war. Nach dem Zuschalten sorgt er für eine schnelle Entladung der Y-Kondensatoren des betroffenen Hochvoltpotentials.

Die Schutzschaltung umfasst somit beispielsweise die elektrische Reihenschaltung des Entladewiderstands und des ersten Schutzschalters zwischen der Pluspotentialleitung und der Bezugspotentialleitung und die elektrische Reihenschaltung des Entladewiderstands und des zweiten Schutzschalters zwischen der Minuspotentialleitung und der Bezugspotentialleitung, wobei der Schutzkondensator zum Entladewiderstand elektrisch parallel geschaltet ist. Alternativ umfasst die Schutzschaltung die beiden Schutzschaltungsteile, wobei der erste Schutzschaltungsteil die elektrische Reihenschaltung des ersten Entladewiderstands und des ersten Schutzschalters zwischen der Pluspotentialleitung und der Bezugspotentialleitung umfasst, wobei zum ersten Entladewiderstand ein erster Schutzkondensator elektrisch parallel geschaltet ist, und wobei der zweite Schutzschaltungsteil die elektrische Reihenschaltung des zweiten Entladewiderstands und des zweiten Schutzschalters zwischen der Minuspotentialleitung und der Bezugspotentialleitung umfasst, wobei zum zweiten Entladewiderstand ein zweiter Schutzkondensator elektrisch parallel geschaltet ist.

Beispielsweise ist zum Entladewiderstand nicht nur der Schutzkondensator elektrisch parallel geschaltet, sondern es ist eine elektrische Reihenschaltung aus dem Schutzkondensator und einem Schutzwiderstand elektrisch parallel geschaltet. Mittels des Schutzwiderstands wird vorteilhafterweise ein Strom über den Schutzkondensator begrenzt.

Die Schutzschaltung umfasst somit beispielsweise die elektrische Reihenschaltung des Entladewiderstands und des ersten Schutzschalters zwischen der Pluspotentialleitung und der Bezugspotentialleitung und die elektrische Reihenschaltung des Entladewiderstands und des zweiten Schutzschalters zwischen der Minuspotentialleitung und der Bezugspotentialleitung, wobei die elektrische Reihenschaltung aus dem Schutzkondensator und dem Schutzwiderstand zum Entladewiderstand elektrisch parallel geschaltet ist. Alternativ umfasst die Schutzschaltung die beiden Schutzschaltungsteile, wobei der erste Schutzschaltungsteil die elektrische Reihenschaltung des ersten Entladewiderstands und des ersten Schutzschalters zwischen der Pluspotentialleitung und der Bezugspotentialleitung umfasst, wobei zum ersten Entladewiderstand eine elektrische Reihenschaltung aus dem ersten Schutzkondensator und einem ersten Schutzwiderstand elektrisch parallel geschaltet ist, und wobei der zweite Schutzschaltungsteil die elektrische Reihenschaltung des zweiten Entladewiderstands und des zweiten Schutzschalters zwischen der Minuspotentialleitung und der Bezugspotentialleitung umfasst, wobei zum zweiten Entladewiderstand eine elektrische Reihenschaltung aus dem zweiten Schutzkondensator und einem zweiten Schutzwiderstand elektrisch parallel geschaltet ist.

In einer weiteren Ausführungsform umfasst die Schutzschaltung eine elektrische Reihenschaltung eines elektrischen Widerstands und eines ersten Schutzschalters zwischen der Pluspotentialleitung und der Bezugspotentialleitung und eine elektrische Reihenschaltung des elektrischen Widerstands und eines zweiten Schutzschalters zwischen der Minuspotentialleitung und der Bezugspotentialleitung. Der elektrische Widerstand ist insbesondere ein elektrischer Widerstand mit einem festen Widerstandswert von maximal 800 Ω, insbesondere maximal 600 Ω, insbesondere kleiner, insbesondere wesentlich kleiner, als ein menschlicher Körperwiderstand, d. h. als ein Körperwiderstand einer Person, insbesondere maximal 200 Ω, insbesondere maximal oder kleiner als 50 Ω, beispielsweise kleiner als 5 Ω. Dadurch wird die Durchströmung des menschlichen Körpers deutlich reduziert. Alternativ ist der elektrische Widerstand beispielsweise ein spannungsabhängiger elektrischer Widerstand, welcher derart ausgebildet ist, dass sich ein Widerstandswert des spannungsabhängigen elektrischen Widerstands bei einer sich erhöhenden elektrischen Spannung über Anschlüssen des spannungsabhängigen elektrischen Widerstands reduziert, insbesondere zunehmend reduziert, wobei ein maximaler Widerstandswert des spannungsabhängigen elektrischen Widerstands beispielsweise maximal 800 Ω ist, insbesondere maximal 600 Ω, insbesondere kleiner ist, insbesondere wesentlich kleiner ist, als ein menschlicher Körperwiderstand, d. h. als ein Körperwiderstand einer Person, insbesondere maximal 200 Ω ist, insbesondere maximal oder kleiner als 50 Ω ist, beispielsweise kleiner als 5 Ω ist. Dies gilt somit für alle Widerstandswerte, die der spannungsabhängige elektrische Widerstand bei den auftretenden elektrischen Spannungen über seinen Anschlüssen aufweisen kann. Dadurch wird die Durchströmung des menschlichen Körpers deutlich reduziert. Der spannungsabhängige elektrische Widerstand ist somit so gestaltet, dass sein Widerstandswert mit zunehmender Spannung über seinen Anschlüssen kleinere Widerstandswerte annimmt.

Diese Ausführungsform der Schutzschaltung ist eine bauteiloptimierte Schutzschaltung. Bei der Schutzschaltung, welche einer Reduzierung eines CY-Schlages dient, d. h. eines Stromschlages einer Person durch Y-Kondensatoren, ist davon auszugehen, dass nur ein Potential, d. h. ein Pluspotential oder ein Minuspotential, über einen Körperwiderstand der Person mit einer Gehäusemasse verbunden ist. Wären beide Potentiale mit der Gehäusemasse verbunden, würde dies einem Kurzschluss einer Batterie eines Fahrzeugs, bei Verwendung der Schutzvorrichtung im Fahrzeug, oder einem Kurzschluss einer Gleichstromladestation, beispielsweise Ladesäule, bei Verwendung der Schutzvorrichtung in der Gleichstromladestation, gleichkommen, der durch eine Sicherung oder einen Stromsensor mit dadurch gesteuerter Abschaltvorrichtung getrennt werden muss. Dadurch wird ersichtlich, dass die Schutzschaltung für das Pluspotential und das Minuspotential nie zur selben Zeit zum Einsatz kommt. Somit kann der elektrische Widerstand auf die beschriebene Weise zur Absicherung beider Potentiale verwendet werden.

Alternativ umfasst die Schutzschaltung zwei Schutzschaltungsteile, wobei der erste Schutzschaltungsteil eine elektrische Reihenschaltung eines ersten elektrischen Widerstands und eines ersten Schutzschalters zwischen der Pluspotentialleitung und der Bezugspotentialleitung umfasst und der zweite Schutzschaltungsteil eine elektrische Reihenschaltung eines zweiten elektrischen Widerstands und eines zweiten Schutzschalters zwischen der Minuspotentialleitung und der Bezugspotentialleitung umfasst. Der jeweilige elektrische Widerstand ist ein elektrischer Widerstand mit dem oben angegebenen festen Widerstandswert. Dadurch wird die Durchströmung des menschlichen Körpers deutlich reduziert. Alternativ ist der jeweilige elektrische Widerstand ein spannungsabhängiger elektrischer Widerstand, welcher derart ausgebildet ist, dass sich ein Widerstandswert des spannungsabhängigen elektrischen Widerstands bei einer sich erhöhenden elektrischen Spannung über Anschlüssen des spannungsabhängigen elektrischen Widerstands reduziert, insbesondere zunehmend reduziert, wobei ein maximaler Widerstandswert des spannungsabhängigen elektrischen Widerstands den oben angegebenen Werten für den maximalen Widerstandswert entspricht. Dies gilt somit für alle Widerstandswerte, die der spannungsabhängige elektrische Widerstand bei den auftretenden elektrischen Spannungen über seinen Anschlüssen aufweisen kann. Dadurch wird die Durchströmung des menschlichen Körpers deutlich reduziert. Der spannungsabhängige elektrische Widerstand ist somit so gestaltet, dass sein Widerstandswert mit zunehmender Spannung über seinen Anschlüssen kleinere Widerstandswerte annimmt.

Bei der oben beschriebenen Ausführungsform der Schutzschaltung, die nur den einen elektrischen Widerstand umfasst, d. h. den selben elektrischen Widerstand für die elektrische Reihenschaltung mit dem ersten Schutzschalter zwischen der Pluspotentialleitung und der Bezugspotentialleitung und mit dem zweiten Schutzschalter zwischen der Minuspotentialleitung und der Bezugspotentialleitung verwendet, ist dabei insbesondere vorgesehen, dass nicht beide Schutzschalter, insbesondere nicht gleichzeitig, zum Schließen ansteuerbar sind bzw. angesteuert werden, sondern jeweils nur einer der beiden Schutzschalter.

Die beschriebene Lösung löst die mit Y-Kondensatoren in Fahrzeugen, insbesondere in Elektrofahrzeugen und Hybridfahrzeugen, und in Gleichstromladestationen verbundenen Probleme, wie im Folgenden erläutert wird. Solche Y-Kondensatoren werden als Maßnahmen verwendet, um Emission von EMV-Störungen zu reduzieren (EMV = elektromagnetische Verträglichkeit). Allerdings stellen sie ein erhöhtes Gefährdungspotential aus Hochvoltsicherheitsgründen dar. In verschiedenen Normen werden eine enthaltene Ladungsmenge oder eine gespeicherte Energie der Y-Kondensatoren als gesundheitsgefährdendes Merkmal genannt. Beispielsweise wird in der Norm SAE J1772, IEC60479-1 und -2 die enthaltene Ladungsmenge in den Y-Kondensatoren als gesundheitsgefährdendes Merkmal genannt (C1-Kennlinie). Mit zunehmender Betriebsspannung des Fahrzeugs wird es immer schwieriger, geforderte Grenzwerte dieser Normen einzuhalten. Teilweise sind auch alternative Maßnahmen, so genannte alternative Measures, zur Einhaltung von Sicherheitsvorgaben, beispielsweise eine verstärkte, insbesondere doppelte, elektrische Isolation, nicht zugelassen. Die weitere Norm LV123 und damit verbundene Normen schreiben beispielsweise einen maximalen Energieinhalt von 0,2 J für die Ladungsmenge aller Y-Kondensatoren vor. Wenn der Ausweg über die alternativen Maßnahmen erlaubt ist, dann kann beispielsweise die bereits erwähnte verstärkte, insbesondere doppelte, elektrische Isolation verwendet werden. Dies ist jedoch nur umsetzbar, wenn alle Hochvoltsysteme, die miteinander gekoppelt werden, entsprechend verstärkt isoliert sind. D. h., dass beispielsweise beim Gleichstromladen sowohl das Fahrzeug als auch die Gleichstromladestation, insbesondere Ladesäule, entsprechend verstärkt isoliert sein müssen. Da hierfür jedoch kein zwingender Standard existiert, wären auch Kopplungen von Systemen mit unterschiedlichen Isolationsauslegungen möglich, wodurch die Sicherheitsanforderungen nicht eingehalten werden.

Dieses Problem wird durch die beschriebene Schaltung gelöst, denn durch eine Spannungsmessung je Hochvoltpotential zum Bezugspotential, insbesondere Massepotential, wird eine Verschiebung der Hochvoltpotentiale, bezogen auf das Bezugspotential, erkannt, welche die Folge eines Körperstroms sein kann, d. h. die Folge eines, insbesondere menschlichen, Körperkontakts mit einem der Hochvoltpotentiale und mit dem Bezugspotential. Um beim betroffenen Hochvoltpotential, bei welchem sich die Spannung zum Bezugspotential reduziert, die Spannung so schnell wie möglich zu reduzieren, wird der Widerstand hinzugeschaltet. Die Spannung zwischen dem betroffenen Hochvoltpotential zum Bezugspotential springt dadurch schlagartig auf ein wesentlich niedrigeres Niveau, wodurch sich der Körperstrom proportional zur Spannung reduziert. Die beschriebene Lösung ermöglicht somit eine Reduzierung eines durch die Y-Kondensatoren verursachten elektrischen Schlags für den, insbesondere menschlichen, Körper. Eine Einhaltung der oben beschriebenen Anforderungen wird somit ermöglicht. Ebenfalls ist es möglich, die durch den Körperwiderstand umgesetzte elektrische Energie der Y-Kondensatoren auf ein Maß unterhalb von 0,2 J zu begrenzen, obwohl die in den Y-Kondensatoren gespeicherte Energie wesentlich höher sein kann.

Der Vorteil der Schutzschaltung der Schutzvorrichtung mit der elektrischen Reihenschaltung des Widerstandes bzw. des ersten und zweiten Widerstandes mit dem jeweiligen Schutzschalter zwischen der jeweiligen Potentialleitung und der Bezugspotentialleitung, gegenüber einer elektrisch mit dem jeweiligen Schutzschalter in Reihe geschalteten Parallelschaltung eines mit einem Schutzwiderstand in Reihe geschalteten Kondensators und eines Entladewiderstandes liegt darin, dass die Schutzschaltung der beschriebenen Lösung keinen solchen Entladewiderstand benötigt. Dadurch wird automatisch beim Erreichen kleinerer Spannungen zwischen Pluspotential und Bezugspotential bzw. zwischen Minuspotential und Bezugspotential zu einem Zustand mit höheren Isolationswiderständen zurückgekehrt, obwohl der erste und/oder der zweite Schutzschalter noch geschlossen sind. Bei der Schutzschaltung mit der elektrisch mit dem jeweiligen Schutzschalter in Reihe geschalteten Parallelschaltung des mit dem Schutzwiderstand in Reihe geschalteten Kondensators und des Entladewiderstandes würde der Schutzwiderstand bei einem geschlossenen ersten oder zweiten Schutzschalter den gesamten Isolationswert eines Hochvolt-Systems, insbesondere des Gleichstromnetzes, beispielsweise des Bordnetzes des Fahrzeugs, auf einen kleineren Wert reduzieren. Dies wird durch die beschriebene Lösung vermieden.

Die Schutzschaltung der beschriebenen Lösung kann zudem bei sehr schnell hintereinander ablaufenden Berührungen eines Hochvoltpotentials, d. h. des Pluspotentials oder des Minuspotentials, jedesmal einen gleichwertigen Ableitpfad zum Körperstrom darstellen. Bei der Schutzschaltung mit der elektrisch mit dem jeweiligen Schutzschalter in Reihe geschalteten Parallelschaltung des mit dem Schutzwiderstand in Reihe geschalteten Kondensators und des Entladewiderstandes muss im Gegensatz dazu entweder abgewartet werden, bis über den Entladewiderstand der Schutzkondensator auf einen sehr kleinen Spannungswert entladen wurde, oder diese Schutzschaltung stellt mit schnell aufeinanderfolgenden Körperkontakten zu einem Hochvoltpotential eine abnehmende Schutzwirkung dar, denn der Schutzkondensator verfügt noch über eine Restspannung und kann nicht mehr so viel Energie speichern.

Es ist daher vorteilhafterweise vorgesehen, dass die hier beschriebene Schutzvorrichtung, insbesondere deren Schutzschaltung, so konzipiert ist, dass sie in der Lage ist, autark Zuschalten zu können, d. h. den ersten und/oder zweiten Schutzschalter zu schließen, und nach kurzer Verweildauer in diesem zugeschalteten Zustand den jeweiligen geschlossenen Schutzschalter wieder zu öffnen. Auf eine Kommunikation innerhalb des Fahrzeugs zu einem übergeordneten Steuergerät, welches Maßnahmen wie beispielsweise ein Öffnen von Schützen, insbesondere Ladeschützen und/oder Hauptschützen, und ein Entladen der Y-Kondensatoren durchführt, wird hierbei vorteilhafterweise verzichtet. Die Erkennung eines permanent anliegenden Isolationsfehlers, d. h. eines niedrigen Isolationswiderstandes und nicht beispielsweise eines defekten Schutzmantels eines Hochvoltkabels, wird vorteilhafterweise durch ein anderes Gerät erkannt, beispielsweise durch einen Isolationswächter und/oder durch eine Messung einer Hochvolt-Potentialverteilung, welches nicht Bestandteil der hier beschriebenen Schutzvorrichtung und deren Schutzschaltung ist und auch nicht mit dieser in Verbindung steht. Wie erwähnt, ist die hier beschriebene Schutzvorrichtung und deren Schutzschaltung in der Lage, wiederholt in sehr kurzen Abständen und somit auch bei schnell wiederkehrenden Berührungen durch eine Person, auszulösen und somit einen Schutz für die Person sicherzustellen. Ein versehentliches Auslösen, zum Beispiel aufgrund einer EMV-Störung, führt nicht zu weiterführenden Maßnahmen im Fahrzeug, wie beispielsweise einem fälschlichen Abschalten des Hochvoltsystems. Durch die autarke Funktion der Schutzvorrichtung, insbesondere von deren Schutzschaltung, ist eine flexible und einfache Integration in ein bestehendes Hochvoltsystem umsetzbar. Durch die autarke Funktion werden zudem die Sicherheitsanforderungen an die Schutzvorrichtung und deren Schutzschaltung reduziert, beispielsweise entfällt eine gesicherte Funktion/Kommunikation zu einem weiteren Steuergerät.

Im Gegensatz zur Schutzschaltung mit der elektrisch mit dem jeweiligen Schutzschalter in Reihe geschalteten Parallelschaltung des mit dem Schutzwiderstand in Reihe geschalteten Kondensators und des Entladewiderstandes führt die hier beschriebene Lösung zu keiner Erhöhung der Gesamtkapazität zwischen Pluspotential und Bezugspotential und zwischen Minuspotential und Bezugspotential.

Bei einem Vergleich der hier beschriebenen Lösung mit der Schutzschaltung mit der elektrisch mit dem jeweiligen Schutzschalter in Reihe geschalteten Parallelschaltung des mit dem Schutzwiderstand in Reihe geschalteten Kondensators und des Entladewiderstandes, zeigt sich, dass im Moment des Zuschaltens der Schutzschaltung der ungeladene Kondensator über eine geringere Impedanz verfügt, wodurch eine schnellere Reduzierung des Körperstromes erreicht werden kann. Die übertragene Ladung und die im menschlichen Körper umgesetzte Energie sind daher im ersten Moment etwas geringer. Im weiteren zeitlichen Verlauf wird der Kondensator jedoch aufgeladen und seine Impedanz nimmt somit zu. Der als spannungsabhängiger Widerstand in Form eines Varistors ausgebildete elektrische Widerstand der hier beschriebenen Lösung bleibt jedoch bis zum Erreichen seiner Varistorspannung von beispielsweise 80 V nahezu konstant und kann somit den Körperstrom im weiteren Verlauf schneller reduzieren.

In einer möglichen Ausführungsform ist der spannungsabhängige elektrische Widerstand und somit bei der oben angegebenen Ausführungsform mit dem einen elektrischen Widerstand dieser eine elektrische Widerstand und bei der oben angegebenen alternativen Ausführungsform mit den beiden Schutzschaltungsteilen und dem ersten und zweiten elektrischen Widerstand der erste elektrische Widerstand und/oder der zweite elektrische Widerstand als ein Varistor oder als eine Serienschaltung und/oder Parallelschaltung mehrerer Varistoren, beispielsweise mit und/oder ohne einer Zusatzbeschaltung, ausgebildet. Die Zusatzbeschaltung ist insbesondere ein Serienwiderstand, um den Varistorstrom zu begrenzen.

In einer möglichen Ausführungsform ist der elektrische Widerstand und/oder der erste elektrische Widerstand und/oder der zweite elektrische Widerstand mit einem elektrischen Schutzwiderstand elektrisch in Reihe geschaltet. D. h bei der oben angegebenen Ausführungsform mit dem einen elektrischen Widerstand ist dieser elektrische Widerstand mit einem elektrischen Schutzwiderstand elektrisch in Reihe geschaltet. Die elektrische Reihenschaltung des elektrischen Widerstands und elektrischen Schutzwiderstands bildet dabei ein gemeinsames Entladenetzwerk zwischen dem Pluspotential und dem Bezugspotential und zwischen dem Minuspotential und dem Bezugspotential. Bei der oben angegebenen alternativen Ausführungsform mit den beiden Schutzschaltungsteilen und dem ersten und zweiten elektrischen Widerstand ist der erste elektrische Widerstand mit einem elektrischen Schutzwiderstand elektrisch in Reihe geschaltet und/oder der zweite elektrische Widerstand mit einem elektrischen Schutzwiderstand elektrisch in Reihe geschaltet. Die elektrische Reihenschaltung des jeweiligen elektrischen Widerstands und des jeweiligen elektrischen Schutzwiderstands bildet dabei ein Entladenetzwerk zwischen dem Pluspotential und dem Bezugspotential bzw. ein Entladenetzwerk zwischen dem Minuspotential und dem Bezugspotential. Der elektrische Schutzwiderstand oder der jeweilige elektrische Schutzwiderstand dient der Vermeidung einer Zerstörung des jeweiligen Schutzschalters durch einen zu hohen Strom. Der elektrische Schutzwiderstand oder der jeweilige elektrische Schutzwiderstand kann beispielsweise entfallen, wenn durch den elektrischen Widerstand oder den jeweiligen elektrischen Widerstand, insbesondere in seiner Ausgestaltung als spannungsabhängiger elektrischer Widerstand, stets sichergestellt ist, dass ein maximaler Stromfluss derart begrenzt ist, dass er nicht zu einer Zerstörung des jeweiligen Schutzschalters führen kann.

Als oben erwähnter menschlicher Körperwiderstand, d. h. als Körperwiderstand einer Person, wird, insbesondere gemäß Angaben in zu beachtenden Normen, ein Widerstandswert von 500 Ω angenommen.

In einer weiteren Ausführungsform umfasst die Schutzschaltung eine elektrische Reihenschaltung eines elektrischen Schutzkondensators, eines elektrischen Schutzwiderstands und des ersten Schutzschalters zwischen der Pluspotentialleitung und der Bezugspotentialleitung und eine elektrische Reihenschaltung des elektrischen Schutzkondensators, des elektrischen Schutzwiderstands und des zweiten Schutzschalters zwischen der Minuspotentialleitung und der Bezugspotentialleitung, wobei zum Schutzkondensator und Schutzwiderstand ein elektrischer Entladewiderstand elektrisch parallel geschaltet ist und zum Schutzkondensator oder zum Schutzkondensator und Schutzwiderstand eine elektrische Reihenschaltung aus einem elektrischen Schnellentladewiderstand und einem Schnellentladeschalter elektrisch parallel geschaltet ist.

Diese Ausführungsform der Schutzschaltung ist eine bauteiloptimierte Schutzschaltung. Bei der Schutzschaltung, welche einer Reduzierung eines CY-Schlages dient, d. h. eines Stromschlages einer Person durch Y-Kondensatoren, ist davon auszugehen, dass nur ein Potential, d. h. ein Pluspotential oder ein Minuspotential, über einen Körperwiderstand der Person mit einer Gehäusemasse verbunden ist. Wären beide Potentiale mit der Gehäusemasse verbunden, würde dies einem Kurzschluss einer Batterie eines Fahrzeugs, bei Verwendung der Schutzvorrichtung im Fahrzeug, oder einen Kurzschluss einer Gleichstromladestation, beispielsweise Ladesäule, bei Verwendung der Schutzvorrichtung in der Gleichstromladestation, gleichkommen, der durch eine Sicherung oder einen Stromsensor mit dadurch gesteuerter Abschaltvorrichtung getrennt werden muss. Dadurch wird ersichtlich, dass die Schutzschaltung für das Pluspotential und das Minuspotential nie zur selben Zeit zum Einsatz kommt. Somit kann diese Ausführungsform der Schutzschaltung auf die beschriebene Weise zur Absicherung beider Potentiale verwendet werden.

In einem Verfahren zum Betrieb dieser Ausführungsform der Schutzvorrichtung wird der erste Schutzschalter oder der zweite Schutzschalter bei Eintritt der Auslösekriterien geschlossen und nach einem Aufladen des Schutzkondensators wieder geöffnet und danach der Schnellentladeschalter geschlossen und nach einem Entladen des Schutzkondensators wieder geöffnet.

Vorteilhafterweise ist bei dieser Ausführungsform der Schutzschaltung vorgesehen, dass nicht beide Schutzschalter, insbesondere nicht gleichzeitig, zum Schließen ansteuerbar sind bzw. angesteuert werden, sondern jeweils nur einer der beiden Schutzschalter, insbesondere in Abhängigkeit davon.

In einer alternativen Ausführungsform umfasst die Schutzschaltung zwei Schutzschaltungsteile. Der erste Schutzschaltungsteil umfasst eine elektrische Reihenschaltung eines ersten elektrischen Schutzkondensators, eines ersten elektrischen Schutzwiderstands und des ersten Schutzschalters zwischen der Pluspotentialleitung und der Bezugspotentialleitung, wobei zum ersten Schutzkondensator und ersten Schutzwiderstand ein erster elektrischer Entladewiderstand elektrisch parallel geschaltet ist und zum ersten Schutzkondensator oder zum ersten Schutzkondensator und ersten Schutzwiderstand eine elektrische Reihenschaltung aus einem ersten elektrischen Schnellentladewiderstand und einem ersten Schnellentladeschalter elektrisch parallel geschaltet ist. Der zweite Schutzschaltungsteil umfasst eine elektrische Reihenschaltung eines zweiten elektrischen Schutzkondensators, eines zweiten elektrischen Schutzwiderstands und des zweiten Schutzschalters zwischen der Minuspotentialleitung und der Bezugspotentialleitung, wobei zum zweiten Schutzkondensator und zweiten Schutzwiderstand ein zweiter elektrischer Entladewiderstand elektrisch parallel geschaltet ist und zum zweiten Schutzkondensator oder zum zweiten Schutzkondensator und zweiten Schutzwiderstand eine elektrische Reihenschaltung aus einem zweiten elektrischen Schnellentladewiderstand und einem zweiten Schnellentladeschalter elektrisch parallel geschaltet ist.

Im Verfahren zum Betrieb der Schutzvorrichtung wird dann entsprechend der erste Schutzschalter bei Eintritt der Auslösekriterien geschlossen und nach einem Aufladen des ersten Schutzkondensators wieder geöffnet und danach der erste Schnellentladeschalter geschlossen und nach einem Entladen des ersten Schutzkondensators wieder geöffnet, und/oder der zweite Schutzschalter wird bei Eintritt der Auslösekriterien geschlossen und nach einem Aufladen des zweiten Schutzkondensators wieder geöffnet und danach der zweite Schnellentladeschalter geschlossen und nach einem Entladen des zweiten Schutzkondensators wieder geöffnet.

Die beschriebene Lösung löst die mit Y-Kondensatoren in Fahrzeugen, insbesondere in Elektrofahrzeugen und Hybridfahrzeugen, und in Gleichstromladestationen verbundenen Probleme, wie im Folgenden erläutert wird. Solche Y-Kondensatoren werden als Maßnahmen verwendet, um Emission von EMV-Störungen zu reduzieren (EMV = elektromagnetische Verträglichkeit). Allerdings stellen sie ein erhöhtes Gefährdungspotential aus Hochvoltsicherheitsgründen dar. Beispielsweise wird in der Norm SAE J1772, IEC60479-1 und -2 eine enthaltene Ladungsmenge in den Y-Kondensatoren als gesundheitsgefährdendes Merkmal genannt (C1-Kennlinie). Mit zunehmender Betriebsspannung des Fahrzeugs wird es immer schwieriger, geforderte Grenzwerte dieser Normen einzuhalten. Teilweise sind auch alternative Maßnahmen, so genannte alternative Measures, zur Einhaltung von Sicherheitsvorgaben, beispielsweise eine verstärkte, insbesondere doppelte, elektrische Isolation, nicht zugelassen. Die weitere Norm LV123 und damit verbundene Normen schreiben beispielsweise einen maximalen Energieinhalt von 0,2 J für die Ladungsmenge aller Y-Kondensatoren vor. Wenn der Ausweg über die alternativen Maßnahmen erlaubt ist, dann kann beispielsweise die bereits erwähnte verstärkte, insbesondere doppelte, elektrische Isolation verwendet werden. Dies ist jedoch nur umsetzbar, wenn alle Hochvoltsysteme, die miteinander gekoppelt werden, entsprechend verstärkt isoliert sind. D. h., dass beispielsweise beim Gleichstromladen sowohl das Fahrzeug als auch die Gleichstromladestation, insbesondere Ladesäule, entsprechend verstärkt isoliert sein müssen. Da hierfür jedoch kein zwingender Standard existiert, wären auch Kopplungen von Systemen mit unterschiedlichen Isolationsauslegungen möglich, wodurch die Sicherheitsanforderungen nicht eingehalten werden.

Dieses Problem wird durch die beschriebene Schaltung gelöst, denn durch eine Spannungsmessung je Hochvoltpotential zum Bezugspotential, insbesondere Massepotential, wird eine Verschiebung der Hochvoltpotentiale, bezogen auf das Bezugspotential, erkannt, der die Folge eines Körperstroms sein kann, d. h. die Folge eines, insbesondere menschlichen, Körperkontakts mit einem der Hochvoltpotentiale und mit dem Bezugspotential. Um beim betroffenen Hochvoltpotential, bei welchem sich die Spannung zum Bezugspotential reduziert, die Spannung so schnell wie möglich zu reduzieren, wird der Entladewiderstand und vorteilhafterweise elektrisch parallel dazu ein ungeladener Schutzkondensator hinzugeschaltet. Die Spannung zwischen dem betroffenen Hochvoltpotential zum Bezugspotential springt dadurch schlagartig auf ein wesentlich niedrigeres Niveau, wodurch sich der Körperstrom proportional zur Spannung reduziert. Die beschriebene Lösung ermöglicht somit eine Reduzierung eines durch die Y-Kondensatoren verursachten elektrischen Schlags für den, insbesondere menschlichen, Körper. Eine Einhaltung der oben beschriebenen Anforderungen wird somit ermöglicht. Ebenfalls ist es möglich, die durch den Körperwiderstand umgesetzte elektrische Energie der Y-Kondensatoren auf ein Maß unterhalb von 0,2 J zu begrenzen, obwohl die in den Y-Kondensatoren gespeicherte Energie wesentlich höher sein kann.

Die Kombination aus Entladewiderstand und elektrisch parallel geschaltetem Schutzkondensator ist besonders vorteilhaft. Der Entladewiderstand stellt sicher, dass der elektrisch parallel geschaltete Schutzkondensator im Moment des Zuschaltens spannungsfrei war. Nach dem Zuschalten sorgt er für eine schnelle Entladung der Y-Kondensatoren des betroffenen Hochvoltpotentials.

Da zum Entladewiderstand nicht nur der Schutzkondensator elektrisch parallel geschaltet ist, sondern auch die elektrische Reihenschaltung aus dem Schutzkondensator und dem Schutzwiderstand, wird mittels des Schutzwiderstands vorteilhafterweise ein Strom über den Schutzkondensator begrenzt.

Durch den zusätzlichen Schnellentladewiderstand, welcher zumindest zum Schutzkondensator oder zum Schutzkondensator und Schutzwiderstand elektrisch parallel geschaltet ist, kann die Schutzschaltung der beschriebenen Lösung zudem bei sehr schnell hintereinander ablaufenden Berührungen eines Hochvoltpotentials, d. h. des Pluspotentials oder des Minuspotentials, jedes Mal einen gleichwertigen Ableitpfad zum Körperstrom darstellen. Ohne diesen zusätzlichen Schnellentladewiderstand würde der Schutzkondensator nach dem erstmaligen Zuschalten in Abhängigkeit seiner Kapazität zur Kapazität der Y-Kondensatoren des Hochvoltsystems aufgeladen, beispielsweise auf 80 V. Bei sehr kurzfristig erneutem Zuschalten mit dieser Spannung würde über dem menschlichen Körper am Ende eine etwas höhere Spannung anliegen, weil die Ladung im Schutzkondensator nicht vollständig abgebaut werden konnte. Mit jedem weiteren kurzfristigen Zuschalten würde sich somit die Schutzfunktion reduzieren. Es müsste somit entweder abgewartet werden, bis über den Entladewiderstand der Schutzkondensator auf einen sehr kleinen Spannungswert entladen wurde, oder diese Schutzschaltung würde mit schnell aufeinanderfolgenden Körperkontakten zu einem Hochvoltpotential eine abnehmende Schutzwirkung darstellen, denn der Schutzkondensator würde noch über eine Restspannung verfügen und könnte nicht mehr so viel Energie speichern. Dieses Problem wird durch die beschriebene Schutzschaltung gelöst, denn diese Schutzschaltung ist um eine schnelle Entladeschaltung zum Schnellentladen des Schutzkondensators erweitert. Hierbei schaltet, wie beschrieben, zunächst der jeweilige Schutzschalter zu. Nach dem Aufladen es Schutzkondensators wird dieser Schutzschalter wieder geöffnet. Nun erfolgt die Entladung des Schutzkondensators durch den parallel liegenden Schnellentladewiderstand und das Schließen des Schnellentladeschalters. Nach dem Entladen des Schutzkondensators wird der Schnellentladeschalter wieder geöffnet und die Schutzschaltung ist wieder einsatzbereit.

Vorteilhafterweise ist vorgesehen, dass die hier beschriebene Schutzvorrichtung, insbesondere deren Schutzschaltung, so konzipiert ist, dass sie in der Lage ist, autark Zuschalten zu können, d. h. den ersten und/oder zweiten Schutzschalter zu schließen, und nach kurzer Verweildauer in diesem zugeschalteten Zustand den jeweiligen geschlossenen Schutzschalter wieder zu öffnen. Auf eine Kommunikation innerhalb des Fahrzeugs zu einem übergeordneten Steuergerät, welches Maßnahmen wie beispielsweise ein Öffnen von Schützen, insbesondere Ladeschützen und/oder Hauptschützen, und ein Entladen der Y-Kondensatoren durchführt, wird hierbei vorteilhafterweise verzichtet. Die Erkennung eines permanent anliegenden Isolationsfehlers, d. h. eines niedrigen Isolationswiderstandes und nicht beispielsweise eines defekten Schutzmantels eines Hochvoltkabels, wird vorteilhafterweise durch ein anderes Gerät erkannt, beispielsweise durch einen Isolationswächter und/oder durch eine Messung einer Hochvolt-Potentialverteilung, welches nicht Bestandteil der hier beschriebenen Schutzvorrichtung und deren Schutzschaltung ist und auch nicht mit dieser in Verbindung steht. Wie erwähnt, ist die hier beschriebene Schutzvorrichtung und deren Schutzschaltung in der Lage, wiederholt in sehr kurzen Abständen und somit auch bei schnell wiederkehrenden Berührungen durch eine Person auszulösen und somit einen Schutz für die Person sicherzustellen. Ein versehentliches Auslösen, zum Beispiel aufgrund einer EMV-Störung, führt nicht zu weiterführenden Maßnahmen im Fahrzeug, wie beispielsweise einem fälschlichen Abschalten des Hochvoltsystems. Durch die autarke Funktion der Schutzvorrichtung, insbesondere von deren Schutzschaltung, ist eine flexible und einfache Integration in ein bestehendes Hochvoltsystem umsetzbar. Durch die autarke Funktion werden zudem die Sicherheitsanforderungen an die Schutzvorrichtung und deren Schutzschaltung reduziert, beispielsweise entfällt eine gesicherte Funktion/Kommunikation zu einem weiteren Steuergerät.

Ausführungsbeispiele der Erfindung werden im Folgenden anhand von Zeichnungen näher erläutert.

Dabei zeigen:
- Fig. 1: schematisch eine Ausführungsform eines Gleichstromnetzes mit einer Ausführungsform einer Schutzvorrichtung,
- Fig. 2: schematisch eine Ausführungsform einer Schutzvorrichtung,
- Fig. 3: schematisch eine weitere Ausführungsform eines Gleichstromnetzes mit einer Ausführungsform einer Schutzvorrichtung,
- Fig. 4: schematisch eine weitere Ausführungsform einer Schutzvorrichtung,
- Fig. 5: schematisch eine weitere Ausführungsform eines Gleichstromnetzes mit einer Ausführungsform einer Schutzvorrichtung, und
- Fig. 6: schematisch eine weitere Ausführungsform einer Schutzvorrichtung.

Einander entsprechende Teile sind in allen Figuren mit den gleichen Bezugszeichen versehen.

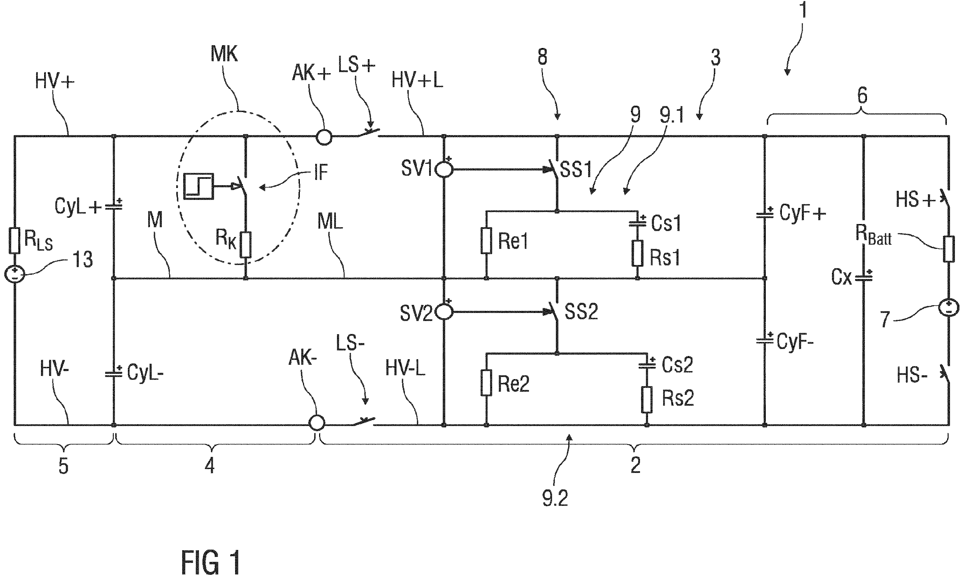

Anhand der Figuren 1 bis 6 wird im Folgenden eine Schutzvorrichtung 8 für ein elektrisches Gleichstromnetz 1, insbesondere für ein Hochvoltnetz, beispielsweise für ein Bordnetz 3 eines Fahrzeugs 2, beschrieben. Sie umfasst eine erste Spannungsmessvorrichtung SV1 zwischen einer Pluspotentialleitung HV+L und einer Bezugspotentialleitung ML zur Messung einer Spannung zwischen der Pluspotentialleitung HV+L und der Bezugspotentialleitung ML und eine zweite Spannungsmessvorrichtung SV2 zwischen einer Minuspotentialleitung HV-L und der Bezugspotentialleitung ML zur Messung einer Spannung zwischen der Minuspotentialleitung HV-L und der Bezugspotentialleitung ML. Das Bezugspotential M ist insbesondere ein elektrisches Massepotential, bei Verwendung der Schutzvorrichtung 8 in einem Fahrzeug 2, insbesondere ein Fahrzeugmassepotential, bei Verwendung der Schutzvorrichtung 8 in einer Gleichstromladestation 5, beispielsweise ein Erdpotential.

Des Weiteren umfasst die Schutzvorrichtung 8 eine Schutzschaltung 9, insbesondere zur Reduzierung eines durch Y-Kondensatoren CyF+, CyF-, CyL+, CyL- des elektrischen Gleichstromnetzes 1 verursachten elektrischen Schlags, insbesondere einer Person, d. h. eines menschlichen Körpers.

Die Schutzschaltung 9 umfasst einen ersten Schutzschalter SS1 zwischen der Pluspotentialleitung HV+L und der Bezugspotentialleitung ML und einen zweiten Schutzschalter SS2 zwischen der Minuspotentialleitung HV-L und der Bezugspotentialleitung ML. Es sind mehrere Auslösekriterien vorgegeben, wobei der erste Schutzschalter SS1 und/oder der zweite Schutzschalter SS2 ausschließlich bei einem mittels der ersten Spannungsmessvorrichtung SV1 und/oder mittels der zweiten Spannungsmessvorrichtung SV2 ermittelten Eintritt aller vorgegebenen Auslösekriterien zum Schließen ansteuerbar sind/ist. Die Auslösekriterien betreffen insbesondere Fehlerursachen/Störungen, die auftreten können und bei deren Auftreten das Schließen der Schutzschalter SS1, SS2 verhindert werden soll. Vorteilhafterweise ist für jede dieser Fehlerursachen/Störungen mindestens ein Auslösekriterium derart vorgegeben, dass es bei Körperkontakt, d. h. bei Kontakt einer Person, d. h. eines menschlichen Körpers, mit einem der Hochvoltpotentiale HV+, HV-, eintritt und bei Auftreten der jeweiligen Fehlerursache nicht eintritt. Die Auslösung, d. h. das Schließen des jeweiligen Schutzschalters SS1, SS2, erfolgt nur, wenn alle vorgegebenen Auslösekriterien eintreten, d. h. erfüllt sind. Dadurch wird sichergestellt, dass der jeweilige Schutzschalter SS1, SS2 nur bei Körperkontakt, d. h. bei Kontakt einer Person, d. h. eines menschlichen Körpers, mit einem der Hochvoltpotentiale HV+, HV- geschlossen wird und ein fehlerhaftes Schließen aufgrund des Auftretens einer oder mehrerer der Fehlerurachen/Störungen sicher vermieden wird.

Ein elektrisches Bordnetz 3, insbesondere Hochvoltbordnetz 3, für ein Fahrzeug 2, insbesondere für ein Elektrofahrzeug oder Hybridfahrzeug, umfasst eine solche Schutzvorrichtung 8.

Ein Fahrzeug 2, insbesondere Elektrofahrzeug oder Hybridfahrzeug, umfasst eine solche Schutzvorrichtung 8, insbesondere ein solches elektrisches Bordnetz 3, insbesondere Hochvoltbordnetz 3, mit einer solchen Schutzvorrichtung 8.

Eine, insbesondere fahrzeugexterne, Gleichstromladestation 5, insbesondere Hochvoltgleichstromladestation, insbesondere zum elektrischen Laden eines

Fahrzeugs 2, insbesondere eines Elektrofahrzeugs oder Hybridfahrzeugs, insbesondere einer Hochvoltbatterie 6 eines solchen Fahrzeugs 2, umfasst eine solche Schutzvorrichtung 8.

Die mittels der Spannungsmessvorrichtungen SV1, SV2 gemessenen Spannungen werden insbesondere wie folgt ausgewertet:
- Ermittlung von Abweichungen aktuell anliegenden Spannungen dU von Pluspotentialleitung HV+L zu Bezugspotentialleitung ML und von Minuspotentialleitung HV-L zu Bezugspotentialleitung ML bezogen auf einen zeitlich zuvor ermittelten Spannungswert, und/oder
- Ermittlung von Spannungsänderungen dU/dt, d. h. über die Zeit, der Spannungen von Pluspotentialleitung HV+L zu Bezugspotentialleitung ML und von Minuspotentialleitung HV-L zu Bezugspotentialleitung ML, und/oder
- Beachtung des entgegengesetzten Vorzeichens, insbesondere bei den obigen beiden Ermittlungen, bezüglich der Auswertung der Spannungen von Pluspotentialleitung HV+L zu Bezugspotentialleitung ML und von Minuspotentialleitung HV-L zu Bezugspotentialleitung ML, und/oder
- Beachten einer zyklischen Wiederholung einer auftretenden Störung.

Die Auslösekriterien umfassen somit insbesondere:
- die Spannungsabweichung der aktuell zwischen der Pluspotentialleitung HV+L und der Bezugspotentialleitung ML anliegenden Spannung und der zwischen der Minuspotentialleitung HV-L und der Bezugspotentialleitung ML anliegenden Spannung vom zeitlich zuvor ermittelten Spannungswert, und/oder
- die Spannungsänderungen über die Zeit der zwischen der Pluspotentialleitung HV+L und der Bezugspotentialleitung ML anliegenden Spannung und der zwischen der Minuspotentialleitung HV-L und der Bezugspotentialleitung ML anliegenden Spannung, und/oder
- das entgegengesetzte Vorzeichen der zwischen der Pluspotentialleitung HV+L und der Bezugspotentialleitung ML anliegenden Spannung und der zwischen der Minuspotentialleitung HV-L und der Bezugspotentialleitung ML anliegenden Spannung, und/oder
- ein Nichtvorliegen einer zyklischen Wiederholung der anderen Auslösekriterien.

Der erste Schutzschalter SS1 und/oder der zweite Schutzschalter SS2 sind/ist insbesondere ausschließlich dann ansteuerbar, wenn
- die Spannungsabweichung der aktuell zwischen der Pluspotentialleitung HV+L und der Bezugspotentialleitung ML anliegenden Spannung und der zwischen der Minuspotentialleitung HV-L und der Bezugspotentialleitung ML anliegenden Spannung von dem zeitlich zuvor ermittelten Spannungswert einen vorgegebenen Grenzwert überschreitet, in einem möglichen Ausführungsbeispiel einen Grenzwert von 30 V, und
- die Spannungsänderungen über die Zeit der zwischen der Pluspotentialleitung HV+L und der Bezugspotentialleitung ML anliegenden Spannung und der zwischen der Minuspotentialleitung HV-L und der Bezugspotentialleitung ML anliegenden Spannung einen vorgegebenen Grenzwert überschreitet, und
- das entgegengesetzte Vorzeichen der zwischen der Pluspotentialleitung HV+L und der Bezugspotentialleitung ML anliegenden Spannung und der zwischen der Minuspotentialleitung HV-L und der Bezugspotentialleitung ML anliegenden Spannung vorliegt.

Beispielsweise ist eine mit den Spannungsmessvorrichtungen SV1, SV2 und den Schutzschaltern SS1, SS2 gekoppelte gemeinsame Spannungsauswerteeinheit 12 zur Auswertung der von der ersten Spannungsmessvorrichtung SV1 ermittelten Spannung und der von der zweiten Spannungsmessvorrichtung SV2 ermittelten Spannung und zur Ansteuerung des ersten Schutzschalters SS1 und/oder des zweiten Schutzschalters SS2 ausschließlich bei dem mittels der ersten Spannungsmessvorrichtung SV1 und/oder mittels der zweiten Spannungsmessvorrichtung SV2 ermittelten Eintritt aller vorgegebenen Auslösekriterien vorgesehen.

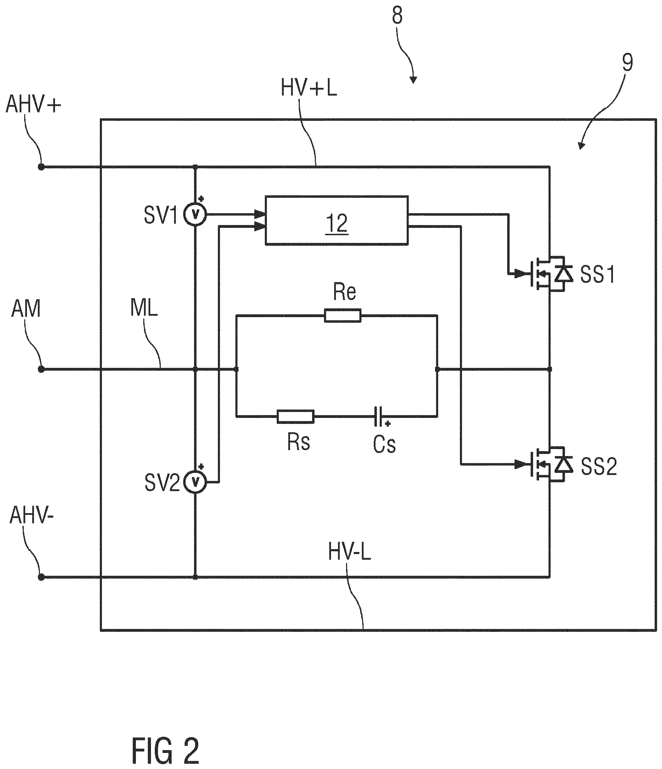

Die Figuren 1 und 2, 3 und 4 sowie 5 und 6 zeigen verschiedene Ausführungsforme der Schutzschaltung 9, wobei die Figuren 2, 4 und 6 eine bauteiloptimierte Version der jeweiligen Ausführungsform zeigen.

Das Hochvoltnetz 3 ist in den dargestellten Beispielen ein Hochvoltbordnetz 3 eines Fahrzeugs 2, insbesondere eines Elektrofahrzeugs oder Hybridfahrzeugs, in welchem die Schutzvorrichtung 8 vorteilhafterweise verwendet wird. Die Schutzvorrichtung 8 ist jedoch alternativ oder zusätzlich auch in einer Gleichstromladestation 5 einsetzbar, an welcher das Fahrzeugs 2 und andere Fahrzeuge, insbesondere Elektrofahrzeuge und Hybridfahrzeuge, zum elektrischen Laden einer Hochvoltbatterie 6 des Fahrzeugs 2 angeschlossen werden können. Das Gleichstromnetz 1 umfasst dann im angeschlossenen Zustand des Fahrzeugs 2 das Bordnetz 3, insbesondere Hochvoltbordnetz 3, des Fahrzeugs 2 und die Gleichstromladestation 5. Die Hochvoltbatterie 6 des Fahrzeugs 2, welche an dieser Gleichstromladestation 5 elektrisch geladen wird, dient insbesondere der Bereitstellung elektrischer Energie für mindestens eine elektrische Antriebseinheit des Fahrzeugs 2 zum Antrieb des Fahrzeugs 2.

Sowohl im Fahrzeug 2 als auch in der Gleichstromladestation 5 werden Y-Kondensatoren CyF+, CyF-, CyL+, CyL- als Maßnahme verwendet, um eine Emission von EMV-Störungen (EMV = elektromagnetische Verträglichkeit) zu reduzieren. Insbesondere sind Y-Kondensatoren CyF+, CyF-, CyL+, CyL- meist günstigere und kompaktere EMV-Filtermaßnahmen im Vergleich zu induktiven Entstörfiltern, beispielsweise Common- oder Differential-Mode Drosseln. Aus Sicht der EMV wäre es somit vorteilhaft, Y-Kondensatoren CyF+, CyF-, CyL+, CyL- mit großen Kapazitätswerten zu verwenden.

Nachteilig bei einem elektrifizierten Fahrzeug 2, d. h. beispielsweise bei einem Elektrofahrzeug oder Hybridfahrzeug, ist jedoch, dass ein Energieinhalt der Y-Kondensatoren CyF+, CyF-, CyL+, CyL- durch einen Fahrzeugnutzer spürbar ist, wenn er ein Hochvoltpotential HV+, HV- berühren kann und gleichzeitig in Verbindung mit dem Erdpotential ist. Er erhält dann einen elektrischen Schlag. Je nach Größe dieses elektrischen Schlages kann dies gesundheitsgefährdend sein. Beispielsweise kann es zu Herzkammerflimmern oder zum Tod führen. Ein solcher elektrischer Schlag stellt einen so genannten "Einfachfehler" dar und ist zu vermeiden. Daher ist dieser Energieinhalt der Y-Kondensatoren CyF+, CyF-, CyL+, CyL- normativ begrenzt, um eine Gefährdung des Fahrzeugnutzers auszuschließen.

Aus Sicht der Hochvoltsicherheit sind somit kleine Kapazitätswerte der Y-Kondensatoren CyF+, CyF-, CyL+, CyL- vorteilhaft. Normativ, beispielsweise geregelt in der Vorschrift LV123, gibt es die Anforderung, einen maximalen Energieinhalt, insbesondere 0,2 J, in den Y-Kondensatoren CyF+, CyF-, CyL+, CyL- nicht zu überschreiten oder so genannte "alternative measures", d. h. alternative Maßnahmen, vorzusehen, zum Beispiel eine verstärkte Isolation. Dies hat jedoch stets zur Folge, dass beim einem Koppeln von zwei Hochvoltsystemen, beispielsweise Fahrzeug 2 und Gleichstromladestation 5, bei der Wahl der verstärkten Isolation als "alternative measure" immer beide Teilnehmer gleichzeitig über diese verstärkte Isolation verfügen müssen. Dies kann derzeit jedoch nicht sichergestellt werden.

In anderen Normen, beispielsweise SAE J1772, IEC 60479-1 und IEC60479-2, wird nicht der Energieinhalt der Y-Kondensatoren CyF+, CyF-, CyL+, CyL- als gesundheitsgefährdende Größe genannt, die nicht überschritten werden darf, sondern es wird eine Ladungsmenge als schädigender Mechanismus genannt, die einen vorgegebenen Wert nicht überschreiten darf. Beispielsweise ist hierzu ein Graph einer Relation einer Dauer eines Körperstroms über einen Wert des Körperstroms angegeben. Ein Alternativweg wie beispielsweise eine verstärkte Isolation wird hier nicht akzeptiert.

Die Figuren 1, 3 und 5 zeigen einen Schaltungsaufbau der jeweiligen Ausführungsform des als Hochvoltnetz ausgebildeten elektrischen Gleichstromnetzes 1 bei einem Gleichstromladevorgang des Fahrzeugs 2. Das Gleichstromnetz 1 umfasst daher das Hochvoltbordnetz 3 des Fahrzeugs 2 und die mittels eines Ladekabels 4 daran angeschlossene Gleichstromladestation 5. Dabei ist im dargestellten Beispiel das Ladekabel 4 bereits mit Anschlusskontakten AK+, AK- eines Gleichstromladeanschlusses des Fahrzeugs 2 verbunden und Ladeschütze LS+, LS- des Fahrzeugs 2 in Hochvoltpotentialleitungen HV+L, HV-L sind noch geöffnet.

Auf der linken Seite befindet sich die Gleichstromladestation 5 mit einer Ladestationsspannungsquelle 13, einem Ladestationinnenwiderstand R_{LS} und den Y-Kondensatoren CyL+, CyL-.

Rechts daneben ist das Ladekabel 4 dargestellt.

Rechts daneben ist das Fahrzeug 2 mit seinem Hochvoltbordnetz 3 dargestellt, umfassend die Ladeschütze LS+, LS-, die Y-Kondensatoren CyF+, CyF-, zum Beispiel EMV-Filter, einen X-Kondensator Cx, beispielsweise eines Gleichstromzwischenkreises, und die Hochvoltbatterie 6 mit ihren Hauptschützen HS+, HS-. Die Hochvoltbatterie 6 ist dargestellt als eine elektrische Batterieenergiequelle 7, umfassend beispielsweise eine Mehrzahl elektrisch in Reihe und/oder parallel geschalteter Einzelzellen, mit einem Batterieinnenwiderstand R_{Batt}.

Zusätzlich ist in diesem Schaltplan der menschliche Körper MK mit einem Körperwiderstand R_{K} und einem Schaltersymbol für einen Isolationsfehler IF, beispielsweise bei einem defekten Ladekabel 4, hier beispielhaft ein Fehler am Pluspotential HV+, dargestellt. Der Isolationsfehler IF kann ebenso am Minuspotential HV- auftreten. Dies ist hier nicht dargestellt. Tritt der Isolationsfehler IF auf, ist das Schaltersymbol geschlossen. Es erfolgt bei einem solchen Isolationsfehler IF und einem Kontakt des menschlichen Körpers MK mit einem der Hochvoltpotentiale HV+, HV- und einem Bezugspotential M eine Entladung durch den menschlichen Körper MK.

Um diese Entladung durch den menschlichen Körper MK zu vermeiden oder zumindest auf ein, insbesondere bezüglich einer Gesundheitsgefährdung, zulässiges Maß zu verringern, ist die Schutzvorrichtung 8 mit der Schutzschaltung 9 zur Reduzierung des Stromschlags durch die Y-Kondensatoren CyF+, CyF-, CyL+, CyL- vorgesehen. Die Schutzvorrichtung 8 umfasst in allen dargestellten Beispielen die beiden Spannungsmessvorrichtungen SV1, SV2 und die Schutzschaltung 9 mit den beiden Schutzschaltern SS1, SS2. Dadurch wird ein Entladenetzwerk zwischen dem Pluspotential HV+ und dem Bezugspotential M, insbesondere der Rohbaumasse, bzw. ein Entladenetzwerk zwischen dem Minuspotential HV- und dem Bezugspotential M, insbesondere der Rohbaumasse, geschalten. Diese Entladenetzwerke sind im Beispiel gemäß den Figuren 1, 3 und 5 die Schutzschaltungsteile 9.1, 9.2 der Schutzschaltung 9.

Das jeweilige Entladenetzwerk, d. h. der jeweilige Schutzschaltungsteil 9.1, 9.2, besteht in der Ausführungsform gemäß den Figuren 1 und 2 vorzugsweise aus einem ungeladenen Kondensator, im Folgenden als Schutzkondensator Cs, Cs1, Cs2 bezeichnet, und einem elektrisch parallel geschalteten Widerstand, im Folgenden als Entladewiderstand Re, Re1, Re2 bezeichnet. Zusätzlich ist ein Schutzwiderstand Rs, Rs1, Rs2 vorgesehen, welcher zum Schutzkondensator Cs, Cs1, Cs2 elektrisch in Reihe geschaltet ist. Es könnte beispielsweise auch nur der Entladewiderstand Re, Re1, Re2 vorgesehen sein, jedoch muss dieser sehr niederohmig sein, um den Körperstrom schnell zu reduzieren. Nachteilig ist jedoch, dass damit ein niederohmiger Isolationsfehler erzeugt wird. Daher wird im Folgenden nur die Kombination mit Schutzkondensator Cs, Cs1, Cs2 und Entladewiderstand Re, Re1, Re2 betrachtet.

Der jeweilige Entladewiderstand Re, Re1, Re2 stellt sicher, dass der elektrisch parallel geschaltete Schutzkondensator Cs, Cs1, Cs2 im Moment des Zuschaltens spannungsfrei war. Nach dem Zuschalten sorgt er für eine schnelle Entladung der Y-Kondensatoren CyF+, CyF-, CyL+, CyL- des betroffenen Hochvoltpotentials HV+, HV-. Im dargestellten Beispiel gemäß Figur 1 ist die Schutzvorrichtung 8 mit der Schutzschaltung 9 im Fahrzeug 2 angeordnet dargestellt. Sie kann aber bei gleicher Funktion auch in der Gleichstromladestation 5 angeordnet sein.

Während des Gleichstromladevorgangs müssen zwar die Hochvoltpotentiale HV+, HV- nicht zwingend symmetrisch bezogen auf das Bezugspotential M verteilt sein, es muss aber ein mindestens einzuhaltender Isolationswert der Hochvoltpotentiale HV+, HV- zum Bezugspotential M sichergestellt werden, beispielsweise größer als 100 Ohm/Volt. Ein Berühren eines Hochvoltpotentials HV+, HV- durch den Menschen äußert sich in einer Reduzierung eines Isolationswiderstandes und daraus resultierend durch eine Verschiebung der Hochvoltpotentiale HV+, HV- bezogen auf das Bezugspotential M.

Ein Isolationswächter im Fahrzeug 2 oder in der Gleichstromladestation 5 prüft zwar zyklisch die Isolationswiderstände, jedoch ist die Zeitspanne bis zur Erkennung eines Isolationsfehlers IF mit maximal 30 Sekunden im Fahrzeug 2 oder maximal zwei Minuten in der Gleichstromladestation 5 viel zu lange, um einen Schutz vor einem Schlag des Menschen bei einer offenen Isolation aus der in den Y-Kondensatoren CyF+, CyF-, CyF+, CyF- gespeicherten Energie darstellen zu können.

Die Funktionsweise der Schutzvorrichtung 8 mit ihrer Schutzschaltung 9 zur Reduzierung eines Cy-Schlages orientiert sich beispielsweise an den in der Norm SAE J1772, IEC 60479-1 und IEC60479-2 beschriebenen Grenzwerten bezüglich des Gefährdungspotentials. Dabei wird als schädigender Mechanismus die Ladungsmenge genannt, die den menschlichen Körper MK durchströmt und in einem Diagramm dargestellt ist. Ziel ist daher eine möglichst schnelle Erkennung und Reduzierung des Körperstromes, um die geflossene Ladung zu minimieren. Ein alleiniges Ansteuern der mechanischen Ladeschütze LS+, LS- und/oder Hauptschütze HS+, HS- wäre dafür zu langsam.

Bei der oben beschriebenen Schutzschaltung 9 wird durch die Spannungsmessung ein Abfall des Isolationswertes schnell erkannt und dadurch sofort, beispielsweise über eine Hardwareschaltung, der entladene Schutzkondensator Cs, Cs1, Cs2 zum betroffenen Hochvoltpotential HV+, HV- mit Körperwiderstand R_{K} bzw.

Y-Kondensator CyF+, CyF-, CyL+, CyL- parallel geschaltet. Somit verringert sich schlagartig die Spannung über diesem Hochvoltpotential HV+, HV- und dem Bezugspotential M. Der Stromfluss durch den menschlichen Körper MK nimmt proportional mit der Spannungsreduzierung ab.

Der Entladewiderstand Re, Re1, Re2 hat dabei zwei Funktionen. Zum einen sorgt er vor dem Zuschalten des Schutzkondensators Cs, Cs1, Cs2 für dessen vollständige Entladung. Zum anderen beschleunigt er nach dem Zuschalten den Abbau der bereits reduzierten Spannung zwischen diesem Hochvoltpotential HV+, HV- und dem Bezugspotential M, wodurch mit weiterhin fallender Spannung auch der Strom durch den menschlichen Körper MK nochmals reduziert wird. Das jeweilig andere Hochvoltpotential HV-, HV+ erhöht im gleichem Maße seine Spannung bezüglich des Bezugspotentials M, wird jedoch nicht durch den menschlichen Körper MK berührt und ist somit unkritisch. In einem weiteren Schritt werden vorteilhafterweise die Hauptschütze HS+, HS- der Hochvoltbatterie 6 geöffnet, Schütze in der Gleichstromladestation 5 und/oder die Ladeschütze LS+, LS- geöffnet und in einem letzten Schritt die aktive Entladung des X-Kondensators Cx und der Y-Kondensatoren CyF+, CyF- des Fahrzeugs 2 durchgeführt.

Durch die Schutzvorrichtung 8 mit deren Schutzschaltung 9 können vorgegebene Normen, beispielsweise die Norm IEC 60479-1, eingehalten werden. Je höher die Gleichstromladespannung ist, desto höher ist die anliegende Spannung über den Y-Kondensatoren CyF+, CyF-, CyL+, CyL-. Daraus resultiert bei einem angenommenen Körperwiderstand R_{K} auch ein zur Spannung der Y-Kondensatoren CyF+, CyF-, CyL+, CyL- proportional höherer Strom zu Beginn des Berührvorgangs. Der Strom durch den Körper nimmt mit dem Verlauf einer Kondensatorentladung über einen Widerstand ab, insbesondere in Form einer Exponentialfunktion. Der Strom zu Beginn des Berührens berechnet sich aus dem Quotient aus Spannung und Widerstand. Bei einer angenommenen maximalen Ladespannung von 920 V ergibt sich bei einer ebenfalls als symmetrisch angenommenen Hochvoltpotentialverteilung bezogen auf das Bezugspotential M (460V über jedem Y-Kondensator) ein Anfangswert des Berührstroms von 460 V / 1200 Ohm = 383 mA. Ausgehend von diesem Anfangswert des Stromes kann durch eine Division mit Wurzel 6 dieser Strom auf einen sinusförmigen AC-Strom umgerechnet werden. Dies entspricht dem Wert auf der X-Achse in der sog. C1-Kennlinie in der Norm SAE J 1772. Die Zeitdauer dieses Stromes kann über das Errechnen der Zeitkonstante der Kondensatorentladung t = R x C ermittelt werden. Die entsprechende Zeitdauer (Y-Achse) entspricht dabei 3 x t. Beispielhaft ist eine Verweildauer in diesem Zustand von ca. 100 ms noch zulässig. Als Ziel wurde ein verbleibender Körperstrom von kleiner als 5 mA gewählt, d. h. die Restspannung muss kleiner als 6 V sein.

Je höher die Spannung über einem Y-Kondensator CyF+, CyF-, CyL+, CyL- ist, beispielsweise bei einer unsymmetrischen Hochvoltpotentialverteilung bezogen auf das Bezugspotential M, desto kürzer ist die maximale Verweildauer. Ein Strom über 500 mA ist nicht erlaubt, da dabei eine maximale Spannung von 600 V über einem Y-Kondensator CyF+, CyF-, CyL+, CyL- auftreten würde. Darüber muss der Ladevorgang abgebrochen werden.

Mittels der Schutzvorrichtung 8 mit ihrer Schutzschaltung 9 kann daher berechnet werden, ob sie noch in der Lage ist, die angeforderten maximalen Strom-Zeitdauern einzuhalten. Ist diese Bedingung nicht erfüllt, muss der Ladevorgang sofort abgebrochen werden, da ein weiterer Fehler zu einer Personengefährdung führen würde. Eingangsgrößen zu dieser Berechnung sind Spannungsmessungen über den Y-Kondensatoren CyF+, CyF-, CyL+, CyL- beider Hochvoltpotentiale HV+, HV-, Kenntnis über die eigene Reaktionsgeschwindigkeit der Schaltung und die Wertetabelle der maximal zulässigen Strom-Verweildauern.

Vorgesehen ist hier eine Spannungsauswerteeinheit 12, in welcher mittels der Spannungsmessvorrichtungen SV1, SV2 erfasste Spannungen ausgewertet werden und die Schutzschalter SS1, SS2 entsprechend angesteuert werden können. Des Weiteren kann vorgesehen sein, dass diese Spannungsauswerteeinheit 12 weitere Informationen ausgeben kann, insbesondere an langsamere Steuergeräte oder an die Gleichstromladestation 5. Beispielhafte Informationen sind ein Öffnen oder Schließen der Ladeschütze LS+, LS-, ein Unterbrechen des Gleichstromladevorgangs, ein Öffnen oder Schließen der Hauptschütze HS+, HS- der Hochvoltbatterie 6, eine Einleitung der aktiven Entladung des Hochvoltzwischenkreises des Fahrzeugs 2 und/oder die Information, dass alles in Ordnung ist und der Gleichstromladevorgang somit gestartet werden kann.

Bei einem Gleichstromnetz 1 ohne die Gleichstromladestation 5, insbesondere für einen Fahrbetrieb des Fahrzeugs 2, einen Wechselstromladebetrieb sowie für Montage- und Servicearbeiten, ist der einzige Unterschied zum Zustand beim Gleichstromladen, dass die Gleichstromladestation 5 fehlt. Als Fehlermechanismus kommen beispielsweise ein defektes Hochvoltkabel oder ein defektes Gehäuse einer Hochvoltelektronik infolge eines Unfalls in Betracht. Auch bei Beschädigungen des Hochvoltsystems während der Montage oder im Service kann die Schutzvorrichtung 8 mit ihrer Schutzschaltung 9 die Ladungsmenge reduzieren.

Die Schutzschaltung 9 zur Reduzierung des Y-Schlages bedingt durch einen Isolationsfehler IF bleibt identisch wie oben beschrieben. Hierfür ist die Schutzvorrichtung 8 mit ihrer Schutzschaltung 9 natürlich im Fahrzeug 2 angeordnet. Die Funktion ist identisch wie zum oben beschrieben Fehler in der Isolation während des Gleichstromladens. Mit dem Erkennen der Verringerung der Spannung zwischen einem der Hochvoltpotentiale HV+, HV- und dem Bezugspotential M wird der jeweilige Schutzkondensator Cs, Cs1, Cs2 hinzugeschaltet und die Gesamtkapazität der Y-Kondensatoren CyF+, CyF-, CyL+, CyL- des betroffenen Hochvoltpotentials HV+, HV- wird entladen. Es wird zudem vorteilhafterweise ein Öffnen der Hauptschütze HS+, HS- der Hochvoltbatterie 6 kommandiert und eine aktive Entladung des X-Kondensators Cx und beider Y-Kondensatoren CyF+, CyF- des Fahrzeugs 2 eingeleitet. Die Ladeschütze LS+, LS- sind bereits vorher geöffnet und bleiben auch immer offen.

Figur 2 zeigt die bauteiloptimierte Schutzschaltung 9. Bei der Schutzschaltung 9 zur Reduzierung eines Cy-Schlages ist davon auszugehen, dass nur ein Hochvoltpotential HV+, HV- über den Körperwiderstand R_{K} mit dem Bezugspotential M, beispielsweise der Gehäusemasse, verbunden ist. Wären beide Hochvoltpotentiale HV+, HV- mit dem Bezugspotential M, insbesondere der Gehäusemasse, verbunden, würde dies einem Kurzschluss der Hochvoltbatterie 6 oder Gleichstromladestation 5 gleich kommen, der durch eine Sicherung oder einen Stromsensor mit dadurch gesteuerter Abschaltvorrichtung getrennt werden muss.

Daraus wird deutlich, dass die Schutzschaltung 9 zur Reduzierung eines Cy-Schlags für das Pluspotential HV+ und das Minuspotential HV- nie zur selben Zeit zum Einsatz kommt. Daher können ein einziger Schutzkondensator Cs, Entladewiderstand Re und zudem Schutzwiderstand Rs für die Absicherung beider Hochvoltpotentiale HV+, HV- verwendet werden, wie in Figur 2 gezeigt. Es sind somit keine zwei Schutzschaltungsteile 9.1, 9.2 erforderlich. Die Spannungsmessungen mittels der beiden Spannungsmessvorrichtungen SV1, SV2 und die beiden Schutzschalter SS1, SS2 für die Zuschaltung der Schutzschaltung 9 müssen weiterhin bestehen bleiben. Figur 2 zeigt eine solche Bauteiloptimierung. Dies ist sinnvoll, wenn der Entladewiderstand Re aufgrund von beispielsweise hohen Betriebsspannungen oder großen Kapazitäten der Y-Kondensatoren CyF+, CyF-, CyL+, CyL- im Fahrzeug 2 und der Gleichstromladestation 5 ebenfalls größere Bauteilwerte annehmen muss. Die Schutzvorrichtung 8, insbesondere deren Schutzschaltung 9, ist hier reduziert auf den notwendigen Zusatzaufwand, der im Fahrzeug 2 oder an der Gleichstromladestation 5 zu integrieren ist. Anschlüsse AHV+, AHV-, AM zum Pluspotential HV+, Minuspotential HV- und Bezugspotential M können sehr klein gehalten werden, da nur im Fehlerfall ein Strom im Millisekundenbereich fließt. Ansonsten sind die Anschlüsse AHV+, AHV-, AM stromfrei und dienen nur zur Spannungsmessung. Daraus folgt, dass eine schnelle Integration der Schutzvorrichtung 8 mit ihrer Schutzschaltung 9 in ein bestehendes Hochvoltsystem mit geringen Änderungen möglich ist. Wenn mehr Planungszeit vorhanden ist, kann diese Funktion selbstverständlich auch in ein bestehendes Gerät integriert werden.

Die Schutzschaltung 9 umfasst somit die eine elektrische Reihenschaltung des Entladewiderstands Re und des ersten Schutzschalters SS1 zwischen der Pluspotentialleitung HV+L und der Bezugspotentialleitung ML und die elektrische Reihenschaltung des, d. h. desselben, Entladewiderstands Re und des zweiten Schutzschalters SS2 zwischen der Minuspotentialleitung HV-L und der Bezugspotentialleitung ML, wie in Figur 2 gezeigt.

Alternativ umfasst die Schutzschaltung 9 zwei Schutzschaltungsteile 9.1, 9.2, wobei der erste Schutzschaltungsteil 9.1 die elektrische Reihenschaltung des ersten Entladewiderstand Re1 und des ersten Schutzschalters SS1 zwischen der Pluspotentialleitung HV+L und der Bezugspotentialleitung ML umfasst und der zweite Schutzschaltungsteil 9.2 die elektrische Reihenschaltung des zweiten Entladewiderstands Re2 und des zweiten Schutzschalters SS2 zwischen der Minuspotentialleitung HV-L und der Bezugspotentialleitung ML umfasst, wie in Figur 1 gezeigt.

Zum Entladewiderstand Re, Re1, Re2 ist vorteilhafterweise, wie oben bereits erwähnt, der Schutzkondensator Cs, Cs1, Cs2, elektrisch parallel geschaltet, d. h. zum alleinigen Entladewiderstand Re ist der alleinige Schutzkondensator Cs elektrisch parallel geschaltet, wie in Figur 2 gezeigt, oder zum Entladewiderstand Re1, Re2 des jeweiligen Schutzschaltungsteils 9.1, 9.2 ist der jeweilige Schutzkondensator Cs1, Cs2 elektrisch parallel geschaltet, wie in Figur 1 gezeigt.

Die Schutzschaltung 9 umfasst somit die elektrische Reihenschaltung des Entladewiderstands Re und des ersten Schutzschalters SS1 zwischen der Pluspotentialleitung HV+L und der Bezugspotentialleitung ML und die elektrische Reihenschaltung des Entladewiderstands Re und des zweiten Schutzschalters SS2 zwischen der Minuspotentialleitung HV-L und der Bezugspotentialleitung ML, wobei der Schutzkondensator Cs zum Entladewiderstand Re elektrisch parallel geschaltet ist, wie in Figur 2 gezeigt. Alternativ umfasst die Schutzschaltung 9 die beiden Schutzschaltungsteile 9.1, 9.2, wobei der erste Schutzschaltungsteil 9.1 die elektrische Reihenschaltung des ersten Entladewiderstand Re1 und des ersten Schutzschalters SS1 zwischen der Pluspotentialleitung HV+L und der Bezugspotentialleitung ML umfasst, wobei zum ersten Entladewiderstand Re1 der erste Schutzkondensator Cs1 elektrisch parallel geschaltet ist, und wobei der zweite Schutzschaltungsteil 9.2 die elektrische Reihenschaltung des zweiten Entladewiderstands Re2 und des zweiten Schutzschalters SS2 zwischen der Minuspotentialleitung HV-L und der Bezugspotentialleitung ML umfasst, wobei zum zweiten Entladewiderstand Re2 der zweite Schutzkondensator Cs2 elektrisch parallel geschaltet ist, wie in Figur 1 gezeigt.

Zum Entladewiderstand Re, Re1, Re2 ist in den hier dargestellten Beispielen nicht nur der Schutzkondensator Cs, Cs1, Cs2 elektrisch parallel geschaltet, sondern es ist eine elektrische Reihenschaltung aus dem Schutzkondensator Cs, Cs1, Cs2 und einem Schutzwiderstand Rs, Rs1, Rs2 elektrisch parallel geschaltet.

Die Schutzschaltung 9 umfasst somit die elektrische Reihenschaltung des Entladewiderstands Re und des ersten Schutzschalters SS1 zwischen der Pluspotentialleitung HV+L und der Bezugspotentialleitung ML und die elektrische Reihenschaltung des Entladewiderstands Re und des zweiten Schutzschalters SS2 zwischen der Minuspotentialleitung HV-L und der Bezugspotentialleitung ML, wobei die elektrische Reihenschaltung aus dem Schutzkondensator Cs und dem Schutzwiderstand Rs zum Entladewiderstand Re elektrisch parallel geschaltet ist, wie in Figur 2 gezeigt. Alternativ umfasst die Schutzschaltung 9 die beiden Schutzschaltungsteile 9.1, 9.2, wobei der erste Schutzschaltungsteil 9.1 die elektrische Reihenschaltung des ersten Entladewiderstand Re1 und des ersten Schutzschalters SS1 zwischen der Pluspotentialleitung HV+L und der Bezugspotentialleitung ML umfasst, wobei zum ersten Entladewiderstand Re1 die elektrische Reihenschaltung aus dem ersten Schutzkondensator Cs1 und dem ersten Schutzwiderstand Rs1 elektrisch parallel geschaltet ist, und wobei der zweite Schutzschaltungsteil 9.2 die elektrische Reihenschaltung des zweiten Entladewiderstands Re2 und des zweiten Schutzschalters SS2 zwischen der Minuspotentialleitung HV-L und der Bezugspotentialleitung ML umfasst, wobei zum zweiten Entladewiderstand Re2 die elektrische Reihenschaltung aus dem zweiten Schutzkondensator Cs2 und dem zweiten Schutzwiderstand Rs2 elektrisch parallel geschaltet ist, wie in Figur 1 gezeigt.

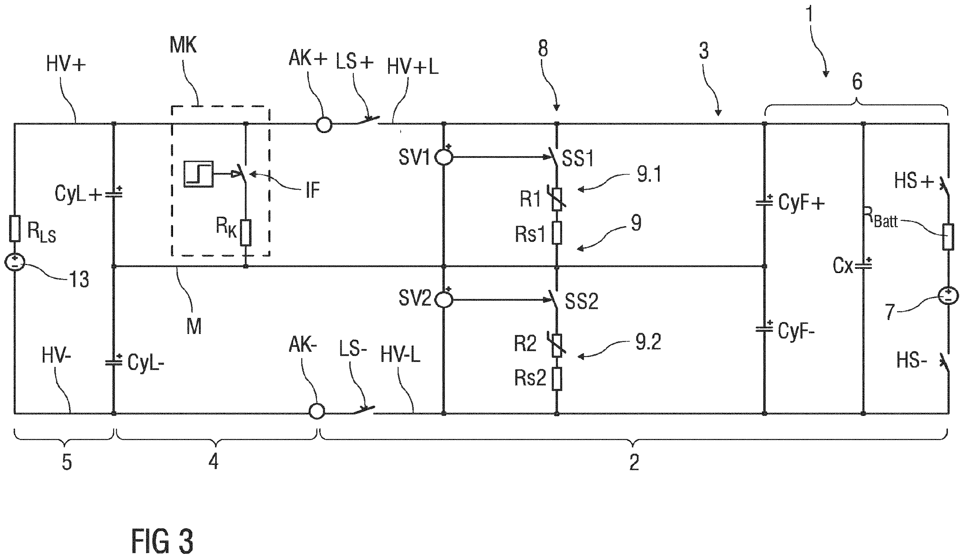

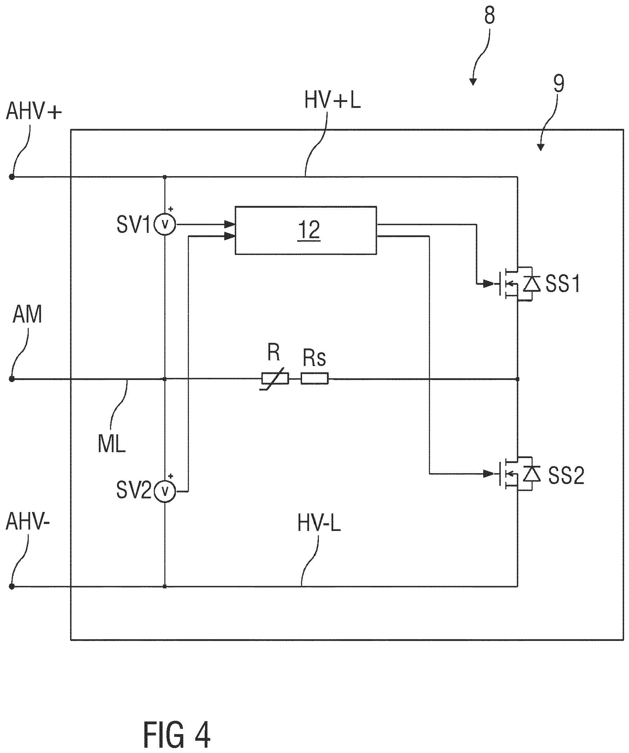

Die Figuren 3 und 4 zeigen eine weitere Ausführungsform der Schutzvorrichtung 8, insbesondere von deren Schutzschaltung 9, wobei Figur 4 die bauteiloptimierte Version zeigt.

Das jeweilige Entladenetzwerk, in Figur 3 somit der jeweilige Schutzschaltungsteil 9.1, 9.2, besteht vorzugsweise aus einer elektrischen Reihenschaltung eines Widerstands R, R1, R2 und eines Schutzwiderstands Rs, Rs1, Rs2.

Der elektrische Widerstand R, R1, R2 ist im dargestellten Beispiel ein spannungsabhängiger elektrischer Widerstand, welcher derart ausgebildet ist, dass sich ein Widerstandswert des spannungsabhängigen elektrischen Widerstands bei einer sich erhöhenden elektrischen Spannung über Anschlüssen des spannungsabhängigen elektrischen Widerstands reduziert, insbesondere zunehmend reduziert, wobei ein maximaler Widerstandswert des spannungsabhängigen elektrischen Widerstands maximal 800 Ω ist, insbesondere maximal 600 Ω, insbesondere kleiner ist, insbesondere wesentlich kleiner ist, als der menschliche Körperwiderstand R_{K}, d. h. als ein Körperwiderstand einer Person, insbesondere maximal 200 Ω ist, insbesondere maximal oder kleiner als 50 Ω ist, beispielsweise kleiner als 5 Ω ist. Dadurch wird die Durchströmung des menschlichen Körpers deutlich reduziert. Der spannungsabhängige Widerstand ist beispielsweise als ein Varistor oder als eine Serienschaltung und/oder Parallelschaltung mehrerer Varistoren, beispielsweise mit und/oder ohne einer Zusatzbeschaltung, ausgebildet.

Alternativ ist der elektrische Widerstand R, R1, R2 ein elektrischer Widerstand mit einem festen Widerstandswert von maximal 800 Ω, insbesondere maximal 600 Ω, der insbesondere kleiner ist, insbesondere wesentlich kleiner ist, als der menschliche Körperwiderstand R_{K}, d. h. als ein Körperwiderstand einer Person, insbesondere maximal 200 Ω beträgt, insbesondere maximal oder kleiner ist als 50 Ω, beispielsweise kleiner als 5 Ω. Dadurch wird ebenfalls die Durchströmung des menschlichen Körpers deutlich reduziert.

Es kann beispielsweise auch nur der Widerstand R, R1, R2 vorgesehen sein. Der elektrische Schutzwiderstand Rs, Rs1, Rs2 dient der Vermeidung einer Zerstörung des jeweiligen Schutzschalters SS1, SS2 durch einen zu hohen Strom. Der elektrische Schutzwiderstand Rs, Rs1, Rs2 kann somit beispielsweise entfallen, wenn durch den elektrischen Widerstand R, R1, R2, insbesondere in seiner Ausgestaltung als spannungsabhängiger elektrischer Widerstand, stets sichergestellt ist, dass ein maximaler Stromfluss derart begrenzt ist, dass er nicht zu einer Zerstörung des jeweiligen Schutzschalters SS1, SS2 führen kann.

Im dargestellten Beispiel gemäß Figur 3 ist die Schutzvorrichtung 8 mit der Schutzschaltung 9 im Fahrzeug 2 angeordnet dargestellt. Sie kann aber bei gleicher Funktion auch in der Gleichstromladestation 5 angeordnet sein.

Bei der hier dargestellten Schutzvorrichtung 8, insbesondere der Schutzschaltung 9, insbesondere des jeweiligen Schutzschaltungsteils 9.1, 9.2, erfolgt eine Fehlererkennung über die Spannungsmessung bezogen auf das Bezugspotential M.

Während eines Gleichstromladevorgangs, bei welchem die in Figur 3 geöffnet dargestellten Ladeschütze LS+, LS- geschlossen sind, müssen zwar die Hochvoltpotentiale HV+, HV- nicht zwingend symmetrisch bezogen auf das Bezugspotential M verteilt sein, es muss aber ein mindestens einzuhaltender Isolationswert der Hochvoltpotentiale HV+, HV- zum Bezugspotential M sichergestellt werden, beispielsweise größer als 100 Ohm/Volt. Ein Berühren eines Hochvoltpotentials HV+, HV- durch den Menschen äußert sich in einer Reduzierung eines Isolationswiderstandes und daraus resultierend durch eine Verschiebung der Hochvoltpotentiale HV+, HV- bezogen auf das Bezugspotential M.

Ein Isolationswächter im Fahrzeug 2 oder in der Gleichstromladestation 5 prüft zwar zyklisch die Isolationswiderstände, jedoch ist die Zeitspanne bis zur Erkennung eines Isolationsfehlers IF mit maximal 30 Sekunden im Fahrzeug 2 oder maximal zwei Minuten in der Gleichstromladestation 5 viel zu lange, um einen Schutz vor einem Schlag des Menschen bei einer offenen Isolation aus der in den Y-Kondensatoren CyF+, CyF-, CyF+, CyF- gespeicherten Energie darstellen zu können.

Die Funktionsweise der Schutzvorrichtung 8 mit ihrer Schutzschaltung 9 zur Reduzierung eines Cy-Schlages orientiert sich beispielsweise an den in der Norm SAE J1772, IEC 60479-1 und IEC60479-2 beschriebenen Grenzwerten bezüglich des Gefährdungspotentials. Dabei wird als schädigender Mechanismus die Ladungsmenge genannt, die den menschlichen Körper MK durchströmt und in einem Diagramm dargestellt ist. Ziel ist daher eine möglichst schnelle Erkennung und Reduzierung des Körperstromes, um die geflossene Ladung zu minimieren. Ein alleiniges Ansteuern der mechanischen Ladeschütze LS+, LS- und/oder Hauptschütze HS+, HS- wäre dafür zu langsam.

Bei der oben beschriebenen Schutzschaltung 9 wird durch die Spannungsmessung ein Abfall des Isolationswertes schnell erkannt und dadurch sofort, beispielsweise über eine Hardwareschaltung, der elektrische Widerstand R, R1, R2 zum betroffenen Hochvoltpotential HV+, HV- mit Körperwiderstand R_{K} bzw.

Y-Kondensator CyF+, CyF-, CyL+, CyL- parallel geschaltet. Somit verringert sich schlagartig die Spannung über diesem Hochvoltpotential HV+, HV- und dem Bezugspotential M. Der Stromfluss durch den menschlichen Körper MK nimmt proportional mit der Spanungsreduzierung ab.

Das jeweilig andere Hochvoltpotential HV-, HV+ erhöht im gleichem Maße seine Spannung bezüglich des Bezugspotentials M, wird jedoch nicht durch den menschlichen Körper MK berührt und ist somit unkritisch.

In einem weiteren Schritt werden vorteilhafterweise die Hauptschütze HS+, HS- der Hochvoltbatterie 6 geöffnet, Schütze in der Gleichstromladestation 5 und/oder die Ladeschütze LS+, LS- geöffnet und in einem letzten Schritt die aktive Entladung des X-Kondensators Cx und der Y-Kondensatoren CyF+, CyF- des Fahrzeugs 2 durchgeführt.

Durch die Schutzvorrichtung 8 mit deren Schutzschaltung 9 können vorgegebene Normen, beispielsweise die Norm IEC 60479-1, eingehalten werden. Je höher die Gleichstromladespannung ist, desto höher ist die anliegende Spannung über den Y-Kondensatoren CyF+, CyF-, CyL+, CyL-. Daraus resultiert bei einem angenommenen Körperwiderstand R_{K} auch ein zur Spannung der Y-Kondensatoren CyF+, CyF-, CyL+, CyL- proportional höherer Strom zu Beginn des Berührvorgangs. Der Strom durch den Körper nimmt mit dem Verlauf einer Kondensatorentladung über einen Widerstand ab, insbesondere in Form einer Exponentialfunktion. Der Strom zu Beginn des Berührens berechnet sich aus dem Quotient aus Spannung und Widerstand. Bei einer angenommenen maximalen Ladespannung von 920 V ergibt sich bei einer ebenfalls als symmetrisch angenommenen Hochvoltpotentialverteilung bezogen auf das Bezugspotential M (460V über jedem Y-Kondensator) ein Anfangswert des Berührstroms von 460 V / 1200 Ohm = 383 mA. Ausgehend von diesem Anfangswert des Stromes kann durch eine Division mit Wurzel 6 dieser Strom auf einen sinusförmigen Wechselstrom umgerechnet werden. Dies entspricht dem Wert auf der X-Achse in der sog. C1-Kennlinie in der Norm SAE J 1772. Die Zeitdauer dieses Stromes kann über das Errechnen der Zeitkonstante der Kondensatorentladung t = R x C ermittelt werden. Die entsprechende Zeitdauer (Y-Achse) entspricht dabei 3 x t. Beispielhaft ist eine Verweildauer in diesem Zustand von ca. 100 ms noch zulässig. Als Ziel wurde ein verbleibender Körperstrom von kleiner als 5 mA gewählt, d. h. die Restspannung muss kleiner als 6 V sein.

Je höher die Spannung über einem Y-Kondensator CyF+, CyF-, CyL+, CyL- ist, beispielsweise bei einer unsymmetrischen Hochvoltpotentialverteilung bezogen auf das Bezugspotential M, desto kürzer ist die maximale Verweildauer. Ein Strom über 500 mA ist nicht erlaubt, da dabei eine maximale Spannung von 600 V über einem Y-Kondensator CyF+, CyF-, CyL+, CyL- auftreten würde. Darüber muss der Ladevorgang abgebrochen werden.

Mittels der Schutzvorrichtung 8 mit ihrer Schutzschaltung 9 kann daher berechnet werden, ob sie noch in der Lage ist, die angeforderten maximalen Strom-Zeitdauern einzuhalten. Ist diese Bedingung nicht erfüllt, muss der Ladevorgang sofort abgebrochen werden, da ein weiterer Fehler zu einer Personengefährdung führen würde. Eingangsgrößen zu dieser Berechnung sind Spannungsmessungen über den Y-Kondensatoren CyF+, CyF-, CyL+, CyL- beider Hochvoltpotentiale HV+, HV-, Kenntnis über die eigene Reaktionsgeschwindigkeit der Schaltung und die Wertetabelle der maximal zulässigen Strom-Verweildauern.

Da die Schutzschaltung 9 bei sehr schnell hintereinander ablaufenden Berührungen eines Hochvoltpotentials HV+, HV- jedesmal einen gleichwertigen Ableitpfad zum Körperstrom darstellen kann, ist vorteilhafterweise vorgesehen, dass die hier beschriebene Schutzvorrichtung 8, insbesondere deren Schutzschaltung 9, so konzipiert ist, dass sie in der Lage ist, autark Zuschalten zu können, d. h. den ersten und/oder zweiten Schutzschalter SS1, SS2 zu schließen, und nach kurzer Verweildauer in diesem zugeschalteten Zustand den jeweiligen geschlossenen Schutzschalter SS1, SS2 wieder zu öffnen. Auf eine Kommunikation innerhalb des Fahrzeugs 2 zu einem übergeordneten Steuergerät, welches Maßnahmen wie beispielsweise ein Öffnen der Ladeschütze LS+, LS- und/oder Hauptschütze HS+, HS- und ein Entladen der Y-Kondensatoren CyF+, CyF-, CyL+, CyL- durchführt, wird hierbei vorteilhafterweise verzichtet. Die Erkennung eines permanent anliegenden Isolationsfehlers, d. h. eines niedrigen Isolationswiderstandes und nicht beispielsweise eines defekten Schutzmantels eines Hochvoltkabels, wird vorteilhafterweise durch ein anderes Gerät erkannt, beispielsweise durch einen Isolationswächter und/oder durch eine Messung einer Hochvolt-Potentialverteilung, welches nicht Bestandteil der hier beschriebenen Schutzvorrichtung 8 und deren Schutzschaltung 9 ist und auch nicht mit dieser in Verbindung steht. Wie erwähnt, ist die hier beschriebene Schutzvorrichtung 8 und deren Schutzschaltung 9 in der Lage, wiederholt in sehr kurzen Abständen und somit auch bei schnell wiederkehrenden Berührungen durch eine Person, auszulösen und somit einen Schutz für die Person sicherzustellen. Ein versehentliches Auslösen, zum Beispiel aufgrund einer EMV-Störung, führt nicht zu weiterführenden Maßnahmen im Fahrzeug 2, wie beispielsweise einem fälschlichen Abschalten des Hochvoltsystems. Durch die autarke Funktion der Schutzvorrichtung 8, insbesondere von deren Schutzschaltung 9, ist eine flexible und einfache Integration in ein bestehendes Hochvoltsystem umsetzbar. Durch die autarke Funktion werden zudem die Sicherheitsanforderungen an die Schutzvorrichtung 8 und deren Schutzschaltung 9 reduziert, beispielsweise entfällt eine gesicherte Funktion/Kommunikation zu einem weiteren Steuergerät.

Auch bei einem Gleichstromnetz 1 ohne die Gleichstromladestation 5, insbesondere für einen Fahrbetrieb des Fahrzeugs 2, einen Wechselstromladebetrieb sowie für Montage- und Servicearbeiten, ist die Schutzvorrichtung 8 einsetzbar. Einziger Unterschied zum Zustand beim Gleichstromladen ist, dass die Gleichstromladestation 5 fehlt. Als Fehlermechanismus kommen beispielsweise ein defektes Hochvoltkabel oder ein defektes Gehäuse einer Hochvoltelektronik infolge eines Unfalls in Betracht. Auch bei Beschädigungen des Hochvoltsystems während der Montage oder im Service kann die Schutzvorrichtung 8 mit ihrer Schutzschaltung 9 die Ladungsmenge reduzieren.

Die Schutzschaltung 9 zur Reduzierung des Y-Schlages bedingt durch einen Isolationsfehler IF bleibt dabei identisch wie oben beschrieben. Hierfür ist die Schutzvorrichtung 8 mit ihrer Schutzschaltung 9 natürlich im Fahrzeug 2 angeordnet. Die Funktion ist identisch wie zum Fehler in der Isolation während des Gleichstromladens oben beschrieben. Mit dem Erkennen der Verringerung der Spannung zwischen einem der Hochvoltpotentiale HV+, HV- und dem Bezugspotential M wird der jeweilige elektrische Widerstand R, R1, R2 hinzugeschaltet und die Gesamtkapazität der Y-Kondensatoren CyF+, CyF-, CyL+, CyL- des betroffenen Hochvoltpotentials HV+, HV- wird entladen. Es wird zudem vorteilhafterweise ein Öffnen der Hauptschütze HS+, HS- der Hochvoltbatterie 6 kommandiert und eine aktive Entladung des X-Kondensators Cx und beider Y-Kondensatoren CyF+, CyF- des Fahrzeugs 2 eingeleitet. Die Ladeschütze LS+, LS- sind bereits vorher geöffnet und bleiben auch immer offen.

Figur 4 zeigt die bauteiloptimierte Schutzschaltung 9. Bei der Schutzschaltung 9 zur Reduzierung eines Cy-Schlages ist davon auszugehen, dass nur ein Hochvoltpotential HV+, HV- über den Körperwiderstand R_{K} mit dem Bezugspotential M, beispielsweise der Gehäusemasse, verbunden ist. Wären beide Hochvoltpotentiale HV+, HV- mit dem Bezugspotential M, insbesondere der Gehäusemasse, verbunden, würde dies einem Kurzschluss der Hochvoltbatterie 6 oder Gleichstromladestation 5 gleich kommen, der durch eine Sicherung oder einen Stromsensor mit dadurch gesteuerter Abschaltvorrichtung getrennt werden muss.

Daraus wird deutlich, dass die Schutzschaltung 9 zur Reduzierung eines Cy-Schlags für das Pluspotential HV+ und das Minuspotential HV- nie zur selben Zeit zum Einsatz kommt. Daher können ein einziger Widerstand R und optional ein einziger Schutzwiderstand Rs für die Absicherung beider Hochvoltpotentiale HV+, HV- verwendet werden, wie in Figur 4 gezeigt. Es sind somit keine zwei Schutzschaltungsteile 9.1, 9.2 erforderlich. Die Spannungsmessungen mittels der beiden Spannungsmessvorrichtungen SV1, SV2 und die beiden Schutzschalter SS1, SS2 für die Zuschaltung der Schutzschaltung 9 müssen weiterhin bestehen bleiben.

Die Schutzvorrichtung 8, insbesondere deren Schutzschaltung 9, ist in Figur 4 reduziert auf den notwendigen Zusatzaufwand, der im Fahrzeug 2 oder an der Gleichstromladestation 5 zu integrieren ist. Anschlüsse AHV+, AHV-, AM zum Pluspotential HV+, Minuspotential HV- und Bezugspotential M können sehr klein gehalten werden, da nur im Fehlerfall ein Strom im Millisekundenbereich fließt. Ansonsten sind die Anschlüsse AHV+, AHV-, AM stromfrei und dienen nur zur Spannungsmessung. Daraus folgt, dass eine schnelle Integration der Schutzvorrichtung 8 mit ihrer Schutzschaltung 9 in ein bestehendes Hochvoltsystem mit geringen Änderungen möglich ist. Wenn mehr Planungszeit vorhanden ist, kann diese Funktion selbstverständlich auch in ein bestehendes Gerät integriert werden.

Die Schutzschaltung 9 umfasst somit beispielsweise, wie in Figur 4 gezeigt, die elektrische Reihenschaltung des elektrischen Widerstands R und des ersten Schutzschalters SS1 zwischen der Pluspotentialleitung HV+L und der Bezugspotentialleitung ML und die elektrische Reihenschaltung des, d. h. desselben, elektrischen Widerstands R und des zweiten Schutzschalters SS2 zwischen der Minuspotentialleitung HV-L und der Bezugspotentialleitung ML.

Der elektrische Widerstand R ist beispielsweise ein elektrischer Widerstand mit dem oben genannten festen Widerstandswert, oder, wie in den Figuren 4 gezeigt, ein spannungsabhängiger elektrischer Widerstand, welcher derart ausgebildet ist, dass sich der Widerstandswert des spannungsabhängigen elektrischen Widerstands bei einer sich erhöhenden elektrischen Spannung über den Anschlüssen des spannungsabhängigen elektrischen Widerstands reduziert, insbesondere zunehmend reduziert, wobei der maximale Widerstandswert wie oben beschrieben vorgesehen ist. Dadurch wird die Durchströmung des menschlichen Körpers deutlich reduziert.

Der als spannungsabhängiger elektrischer Widerstand ausgebildete elektrische Widerstand R ist beispielsweise als ein Varistor oder als eine Serienschaltung und/oder Parallelschaltung mehrerer Varistoren mit und/oder ohne einer Zusatzbeschaltung ausgebildet.

Alternativ umfasst die Schutzschaltung 9, wie in Figur 3 gezeigt, zwei Schutzschaltungsteile 9.1, 9.2, wobei der erste Schutzschaltungsteil 9.1 die elektrische Reihenschaltung des ersten elektrischen Widerstands R1 und des ersten Schutzschalters SS1 zwischen der Pluspotentialleitung HV+L und der Bezugspotentialleitung ML umfasst und der zweite Schutzschaltungsteil 9.2 die elektrische Reihenschaltung des zweiten elektrischen Widerstands R2 und des zweiten Schutzschalters SS2 zwischen der Minuspotentialleitung HV-L und der Bezugspotentialleitung ML umfasst.

Der jeweilige elektrische Widerstand R1, R2 ist beispielsweise ein elektrischer Widerstand mit dem oben genannten festen Widerstandswert oder wie in Figur 3 gezeigt, ein spannungsabhängiger elektrischer Widerstand, welcher derart ausgebildet ist, dass sich der Widerstandswert des spannungsabhängigen elektrischen Widerstands bei der sich erhöhenden elektrischen Spannung über den Anschlüssen des spannungsabhängigen elektrischen Widerstands reduziert, insbesondere zunehmend reduziert, wobei der maximale Widerstandswert wie oben angegeben vorgesehen ist. Dadurch wird die Durchströmung des menschlichen Körpers deutlich reduziert.

Der jeweilige als spannungsabhängiger elektrischer Widerstand ausgebildete elektrische Widerstand R1, R2 ist beispielsweise als ein Varistor oder als eine Serienschaltung und/oder Parallelschaltung mehrerer Varistoren mit und/oder ohne einer Zusatzbeschaltung ausgebildet.

In einer möglichen Ausführungsform ist, wie oben bereits erwähnt, der elektrische Widerstand R, R1, R2 mit einem elektrischen Schutzwiderstand Rs, Rs1, Rs2 elektrisch in Reihe geschaltet. D. h. der alleinige elektrische Widerstand R ist mit dem alleinigen elektrischen Schutzwiderstand Rs elektrisch in Reihe geschaltet, wie in Figur 4 gezeigt, oder der elektrische Widerstand R1, R2 des jeweiligen Schutzschaltungsteils 9.1, 9.2 ist mit dem elektrischen Schutzwiderstand Rs1, Rs2 des jeweiligen Schutzschaltungsteils 9.1, 9.2 elektrisch in Reihe geschaltet, wie in Figur 3 gezeigt.

Die elektrische Reihenschaltung des jeweiligen elektrischen Widerstands R, R1, R2 und des jeweiligen elektrischen Schutzwiderstands Rs, Rs1, Rs2 bildet dabei ein Entladenetzwerk zwischen dem Pluspotential HV+ und dem Bezugspotential M bzw. ein Entladenetzwerk zwischen dem Minuspotential HV- und dem Bezugspotential M. Der elektrische Schutzwiderstand Rs oder der jeweilige elektrische Schutzwiderstand Rs1, Rs2 dient der Vermeidung einer Zerstörung des jeweiligen Schutzschalters SS1, SS2 durch einen zu hohen Strom. Der elektrische Schutzwiderstand Rs oder der jeweilige elektrische Schutzwiderstand Rs1, Rs2 kann beispielsweise entfallen, wenn durch den elektrischen Widerstand R oder den jeweiligen elektrischen Widerstand R1, R2, insbesondere in seiner Ausgestaltung als spannungsabhängiger elektrischer Widerstand, stets sichergestellt ist, dass ein maximaler Stromfluss derart begrenzt ist, dass er nicht zu einer Zerstörung des jeweiligen Schutzschalters SS1, SS2 führen kann.

Ist der elektrische Schutzwiderstand Rs bzw. der jeweilige Schutzwiderstand Rs1, Rs2 vorhanden, so umfasst die Schutzschaltung 9 somit die elektrische Reihenschaltung des elektrischen Widerstands R, des elektrischen Schutzwiderstands Rs und des ersten Schutzschalters SS1 zwischen der Pluspotentialleitung HV+L und der Bezugspotentialleitung ML und die elektrische Reihenschaltung des Widerstands R, des elektrischen Schutzwiderstands Rs und des zweiten Schutzschalters SS2 zwischen der Minuspotentialleitung HV-L und der Bezugspotentialleitung ML, wie in Figur 4 gezeigt, oder die Schutzschaltung 9 umfasst die beiden Schutzschaltungsteile 9.1, 9.2, wobei der erste Schutzschaltungsteil 9.1 die elektrische Reihenschaltung des ersten elektrischen Widerstands R1, des ersten elektrischen Schutzwiderstands Rs1 und des ersten Schutzschalters SS1 zwischen der Pluspotentialleitung HV+L und der Bezugspotentialleitung ML umfasst und der zweite Schutzschaltungsteil 9.2 die elektrische Reihenschaltung des zweiten elektrischen Widerstands R2, des zweiten elektrischen Schutzwiderstands Rs2 und des zweiten Schutzschalters SS2 zwischen der Minuspotentialleitung HV-L und der Bezugspotentialleitung ML umfasst, wie in Figur 3 gezeigt.

Als oben erwähnter menschlicher Körperwiderstand R_{K}, d. h. als Körperwiderstand einer Person, d. h. des menschlichen Körpers MK, wird, insbesondere gemäß Angaben in zu beachtenden Normen, ein Widerstandswert von 500 Ω angenommen.

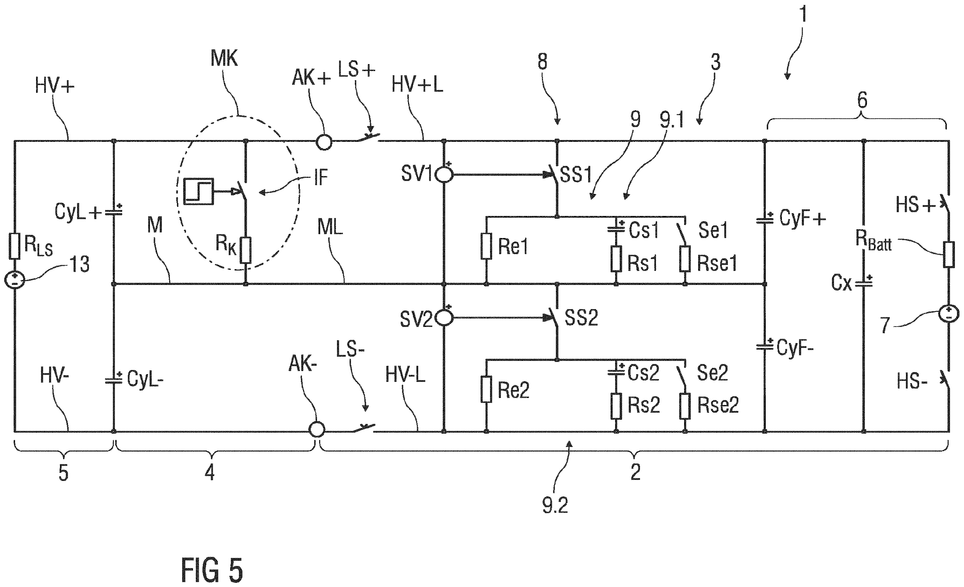

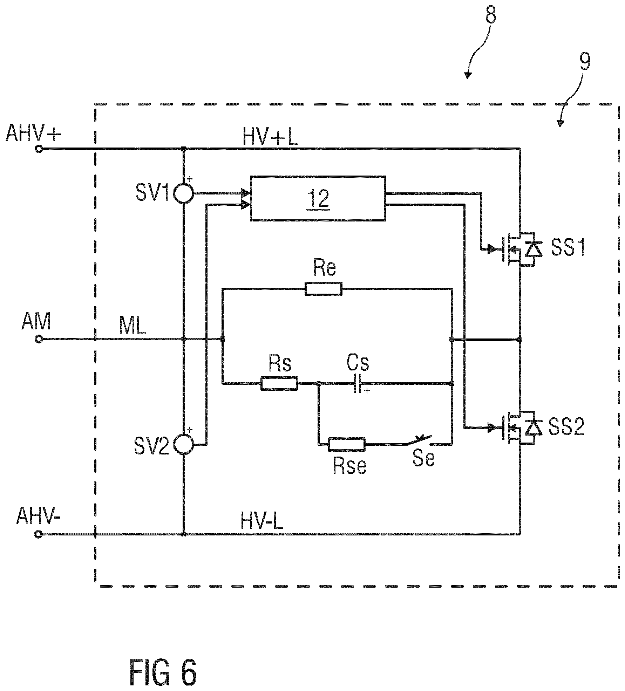

Die Figuren 5 und 6 zeigen eine weitere Ausführungsform der Schutzvorrichtung 8, insbesondere von deren Schutzschaltung 9, wobei Figur 6 die bauteiloptimierte Version zeigt.

Das jeweilige Entladenetzwerk, d. h. in Figur 5 der jeweilige Schutzschaltungsteil 9.1, 9.2, umfasst hier vorzugsweise einen ungeladenen Kondensator, im Folgenden als Schutzkondensator Cs, Cs1, Cs2 bezeichnet, und einen elektrisch parallel geschalteten Widerstand, im Folgenden als Entladewiderstand Re, Re1, Re2 bezeichnet. Zusätzlich ist ein Schutzwiderstand Rs, Rs1, Rs2 vorgesehen, welcher zum Schutzkondensator Cs, Cs1, Cs2 elektrisch in Reihe geschaltet ist. Des Weiteren ist, parallel zum Schutzkondensator Cs, Cs1, Cs2 und beispielsweise auch parallel zum Schutzwiderstand Rs, Rs1, Rs2, ein Schnellentladewiderstand Rse, Rse1, Rse2 vorgesehen, elektrisch in Reihe mit einem Schnellentladeschalter Se, Se1, Se2.

Der jeweilige Entladewiderstand Re, Re1, Re2 stellt sicher, dass der elektrisch parallel geschaltete Schutzkondensator Cs, Cs1, Cs2 im Moment des Zuschaltens spannungsfrei war. Nach dem Zuschalten sorgt er für eine schnelle Entladung der Y-Kondensatoren CyF+, CyF-, CyL+, CyL- des betroffenen Hochvoltpotentials HV+, HV-.

Durch den zusätzlichen Schnellentladewiderstand Rse, Rse1, Rse2 kann die Schutzschaltung 9 zudem bei sehr schnell hintereinander ablaufenden Berührungen eines Hochvoltpotentials HV+, HV- jedes Mal einen gleichwertigen Ableitpfad zum Körperstrom darstellen. Ohne diesen zusätzlichen Schnellentladewiderstand Rse, Rse1, Rse2 würde der Schutzkondensator Cs, Cs1, Cs2 nach dem erstmaligen Zuschalten in Abhängigkeit seiner Kapazität zur Kapazität der Y-Kondensatoren CyF+, CyF-, CyL+, CyL- des Hochvoltsystems aufgeladen, beispielsweise auf 80 V. Bei sehr kurzfristig erneutem Zuschalten mit dieser Spannung würde über dem menschlichen Körper MK am Ende eine etwas höhere Spannung anliegen, weil die Ladung im Schutzkondensator Cs, Cs1, Cs2 nicht vollständig abgebaut werden konnte. Mit jedem weiteren kurzfristigen Zuschalten würde sich somit die Schutzfunktion reduzieren. Es müsste somit entweder abgewartet werden, bis über den Entladewiderstand Re, Re1, Re2 der Schutzkondensator Cs, Cs1, Cs2 auf einen sehr kleinen Spannungswert entladen wurde, oder diese Schutzschaltung würde mit schnell aufeinanderfolgenden Körperkontakten zu einem Hochvoltpotential HV+, HV- eine abnehmende Schutzwirkung darstellen, denn der Schutzkondensator Cs, Cs1, Cs2 würde noch über eine Restspannung verfügen und könnte nicht mehr so viel Energie speichern. Dieses Problem wird durch die beschriebene Schutzschaltung 9 gelöst, denn diese Schutzschaltung 9 ist um eine schnelle Entladeschaltung zum Schnellentladen des Schutzkondensators Cs, Cs1, Cs2 erweitert. Hierbei schaltet zunächst der jeweilige Schutzschalter SS1, SS2 zu. Nach dem Aufladen des Schutzkondensators Cs, Cs1, Cs2 wird dieser Schutzschalter SS1, SS2 wieder geöffnet. Nun erfolgt die Entladung des Schutzkondensators Cs, Cs1, Cs2 durch den parallel liegenden Schnellentladewiderstand Rse, Rse1, Rse2 und das Schließen des Schnellentladeschalters Se, Se1, Se2. Nach dem Entladen des Schutzkondensators Cs, Cs1, Cs2 wird der Schnellentladeschalter Se, Se1, Se2 wieder geöffnet und die Schutzschaltung 9 ist wieder einsatzbereit.

Vorteilhafterweise ist vorgesehen, dass die hier beschriebene Schutzvorrichtung 8, insbesondere deren Schutzschaltung 9, so konzipiert ist, dass sie in der Lage ist, autark Zuschalten zu können, d. h. den ersten und/oder zweiten Schutzschalter SS1, SS2 zu schließen, und nach kurzer Verweildauer in diesem zugeschalteten Zustand den jeweiligen geschlossenen Schutzschalter SS1, SS2 wieder zu öffnen. Auf eine Kommunikation innerhalb des Fahrzeugs 2 zu einem übergeordneten Steuergerät, welches Maßnahmen wie beispielsweise ein Öffnen von Schützen, insbesondere Ladeschützen LS+, LS- und/oder Hauptschützen HS+, HS-, und ein Entladen der Y-Kondensatoren CyF+, CyF-, CyL+, CyL- durchführt, wird hierbei vorteilhafterweise verzichtet. Die Erkennung eines permanent anliegenden Isolationsfehlers, d. h. eines niedrigen Isolationswiderstandes und nicht beispielsweise eines defekten Schutzmantels eines Hochvoltkabels, wird vorteilhafterweise durch ein anderes Gerät erkannt, beispielsweise durch einen Isolationswächter und/oder durch eine Messung einer Hochvolt-Potentialverteilung, welches nicht Bestandteil der hier beschriebenen Schutzvorrichtung 8 und deren Schutzschaltung 9 ist und auch nicht mit dieser in Verbindung steht. Wie erwähnt, ist die hier beschriebene Schutzvorrichtung 8 und deren Schutzschaltung 9 in der Lage, wiederholt in sehr kurzen Abständen und somit auch bei schnell wiederkehrenden Berührungen durch eine Person auszulösen und somit einen Schutz für die Person sicherzustellen. Ein versehentliches Auslösen, zum Beispiel aufgrund einer EMV-Störung, führt nicht zu weiterführenden Maßnahmen im Fahrzeug 2, wie beispielsweise einem fälschlichen Abschalten des Hochvoltsystems. Durch die autarke Funktion der Schutzvorrichtung 8, insbesondere von deren Schutzschaltung 9, ist eine flexible und einfache Integration in ein bestehendes Hochvoltsystem umsetzbar. Durch die autarke Funktion werden zudem die Sicherheitsanforderungen an die Schutzvorrichtung 8 und deren Schutzschaltung 9 reduziert, beispielsweise entfällt eine gesicherte Funktion/Kommunikation zu einem weiteren Steuergerät.

Im dargestellten Beispiel gemäß Figur 5 ist die Schutzvorrichtung 8 mit der Schutzschaltung 9 im Fahrzeug 2 angeordnet dargestellt. Sie kann aber bei gleicher Funktion auch in der Gleichstromladestation 5 angeordnet sein.

Bei der hier dargestellten Schutzvorrichtung 8, insbesondere der Schutzschaltung 9, insbesondere des jeweiligen Schutzschaltungsteils 9.1, 9.2, erfolgt eine Fehlererkennung über die Spannungsmessung bezogen auf das Bezugspotential M.

Während eines Gleichstromladevorgangs, bei welchem die in Figur 5 geöffnet dargestellten Ladeschütze LS+, LS- geschlossen sind, müssen zwar die Hochvoltpotentiale HV+, HV- nicht zwingend symmetrisch bezogen auf das Bezugspotential M verteilt sein, es muss aber ein mindestens einzuhaltender Isolationswert der Hochvoltpotentiale HV+, HV- zum Bezugspotential M sichergestellt werden, beispielsweise größer als 100 Ohm/Volt. Ein Berühren eines Hochvoltpotentials HV+, HV- durch den Menschen äußert sich in einer Reduzierung eines Isolationswiderstandes und daraus resultierend durch eine Verschiebung der Hochvoltpotentiale HV+, HV- bezogen auf das Bezugspotential M.

Ein Isolationswächter im Fahrzeug 2 oder in der Gleichstromladestation 5 prüft zwar zyklisch die Isolationswiderstände, jedoch ist die Zeitspanne bis zur Erkennung eines Isolationsfehlers IF mit maximal 30 Sekunden im Fahrzeug 2 oder maximal zwei Minuten in der Gleichstromladestation 5 viel zu lange, um einen Schutz vor einem Schlag des Menschen bei einer offenen Isolation aus der in den Y-Kondensatoren CyF+, CyF-, CyL+, CyL- gespeicherten Energie darstellen zu können.

Die Funktionsweise der Schutzvorrichtung 8 mit ihrer Schutzschaltung 9 zur Reduzierung eines Cy-Schlages orientiert sich beispielsweise an den in der Norm SAE J1772, IEC 60479-1 und IEC60479-2 beschriebenen Grenzwerten bezüglich des Gefährdungspotentials. Dabei wird als schädigender Mechanismus die Ladungsmenge genannt, die den menschlichen Körper MK durchströmt und in einem Diagramm dargestellt ist. Ziel ist daher eine möglichst schnelle Erkennung und Reduzierung des Körperstromes, um die geflossene Ladung zu minimieren. Ein alleiniges Ansteuern der mechanischen Ladeschütze LS+, LS- und/oder Hauptschütze HS+, HS- wäre dafür zu langsam.

Bei der oben beschriebenen Schutzschaltung 9 wird durch die Spannungsmessung ein Abfall des Isolationswertes schnell erkannt und dadurch sofort, beispielsweise über eine Hardwareschaltung, der entladene Schutzkondensator Cs, Cs1, Cs2 zum betroffenen Hochvoltpotential HV+, HV- mit Körperwiderstand R_{K} bzw.

Y-Kondensator CyF+, CyF-, CyL+, CyL- parallel geschaltet. Somit verringert sich schlagartig die Spannung über diesem Hochvoltpotential HV+, HV- und dem Bezugspotential M. Der Stromfluss durch den menschlichen Körper MK nimmt proportional mit der Spannungsreduzierung ab.

Der Entladewiderstand Re, Re1, Re2 hat dabei zwei Funktionen. Zum einen sorgt er vor dem Zuschalten des Schutzkondensators Cs, Cs1, Cs2 für dessen vollständige Entladung. Zum anderen beschleunigt er nach dem Zuschalten den Abbau der bereits reduzierten Spannung zwischen diesem Hochvoltpotential HV+, HV- und dem Bezugspotential M, wodurch mit weiterhin fallender Spannung auch der Strom durch den menschlichen Körper MK nochmals reduziert wird. Das jeweilig andere Hochvoltpotential HV-, HV+ erhöht im gleichen Maße seine Spannung bezüglich des Bezugspotentials M, wird jedoch nicht durch den menschlichen Körper MK berührt und ist somit unkritisch. In einem weiteren Schritt kann ein Öffnen der Hauptschütze HS+, HS- der Hochvoltbatterie 6, der Schütze in der Gleichstromladestation 5 und/oder der Ladeschütze LS+, LS- erfolgen und in einem letzten Schritt, die aktive Entladung des X-Kondensators Cx und der Y-Kondensatoren CyF+, CyF- des Fahrzeugs 2 durchgeführt werden. Wie oben beschrieben, erfolgt bei der hier beschriebenen Lösung dieses Öffnen der Schütze jedoch nicht, zumindest nicht durch die Schutzvorrichtung 8, sondern es erfolgt auf die oben beschriebene Weise das Schnellentladen des Schutzkondensators Cs, Cs1, Cs2 mittels des Schnellentladewiderstands Rse, Rse1, Rse2, wodurch die Schutzschaltung 9 schnell wieder einsatzbereit ist.

Durch die Schutzvorrichtung 8 mit deren Schutzschaltung 9 können vorgegebene Normen, beispielsweise die Norm IEC 60479-1, eingehalten werden. Je höher die Gleichstromladespannung ist, desto höher ist die anliegende Spannung über den Y-Kondensatoren CyF+, CyF-, CyL+, CyL-. Daraus resultiert bei einem angenommenen Körperwiderstand R_{K} auch ein zur Spannung der Y-Kondensatoren CyF+, CyF-, CyL+, CyL- proportional höherer Strom zu Beginn des Berührvorgangs. Der Strom durch den Körper nimmt mit dem Verlauf einer Kondensatorentladung über einen Widerstand ab, insbesondere in Form einer Exponentialfunktion. Der Strom zu Beginn des Berührens berechnet sich aus dem Quotient aus Spannung und Widerstand. Bei einer angenommenen maximalen Ladespannung von 920 V ergibt sich bei einer ebenfalls als symmetrisch angenommenen Hochvoltpotentialverteilung bezogen auf das Bezugspotential M (460V über jedem Y-Kondensator) ein Anfangswert des Berührstroms von 460 V / 1200 Ohm = 383 mA. Ausgehend von diesem Anfangswert des Stromes kann durch eine Division mit Wurzel 6 dieser Strom auf einen sinusförmigen Wechselstrom umgerechnet werden. Dies entspricht dem Wert auf der X-Achse in der sog. C1-Kennlinie in der Norm SAE J 1772. Die Zeitdauer dieses Stromes kann über das Errechnen der Zeitkonstante der Kondensatorentladung t = R x C ermittelt werden. Die entsprechende Zeitdauer (Y-Achse) entspricht dabei 3 x t. Beispielhaft ist eine Verweildauer in diesem Zustand von ca. 100 ms noch zulässig. Als Ziel wurde ein verbleibender Körperstrom von kleiner als 5 mA gewählt, d. h. die Restspannung muss kleiner als 6 V sein.

Je höher die Spannung über einem Y-Kondensator CyF+, CyF-, CyL+, CyL- ist, beispielsweise bei einer unsymmetrischen Hochvoltpotentialverteilung bezogen auf das Bezugspotential M, desto kürzer ist die maximale Verweildauer. Ein Strom über 500 mA ist nicht erlaubt, da dabei eine maximale Spannung von 600 V über einem Y-Kondensator CyF+, CyF-, CyL+, CyL- auftreten würde. Darüber muss der Ladevorgang abgebrochen werden.

Mittels der Schutzvorrichtung 8 mit ihrer Schutzschaltung 9 kann daher berechnet werden, ob sie noch in der Lage ist, die angeforderten maximalen Strom-Zeitdauern einzuhalten. Ist diese Bedingung nicht erfüllt, muss der Ladevorgang sofort abgebrochen werden, da ein weiterer Fehler zu einer Personengefährdung führen würde. Eingangsgrößen zu dieser Berechnung sind Spannungsmessungen über den Y-Kondensatoren CyF+, CyF-, CyL+, CyL- beider Hochvoltpotentiale HV+, HV-, Kenntnis über die eigene Reaktionsgeschwindigkeit der Schaltung und die Wertetabelle der maximal zulässigen Strom-Verweildauern.

Da die Schutzschaltung 9 bei sehr schnell hintereinander ablaufenden Berührungen eines Hochvoltpotentials HV+, HV- jedes Mal einen gleichwertigen Ableitpfad zum Körperstrom darstellen kann, ist vorteilhafterweise vorgesehen, dass die hier beschriebene Schutzvorrichtung 8, insbesondere deren Schutzschaltung 9, so konzipiert ist, dass sie in der Lage ist, autark zuschalten zu können, d. h. den ersten und/oder zweiten Schutzschalter SS1, SS2 zu schließen, und nach kurzer Verweildauer in diesem zugeschalteten Zustand den jeweiligen geschlossenen Schutzschalter SS1, SS2 wieder zu öffnen. Auf eine Kommunikation innerhalb des Fahrzeugs 2 zu einem übergeordneten Steuergerät, welches Maßnahmen wie beispielsweise ein Öffnen der Ladeschütze LS+, LS- und/oder Hauptschütze HS+, HS- und ein Entladen der Y-Kondensatoren CyF+, CyF-, CyL+, CyL- durchführt, wird hierbei vorteilhafterweise verzichtet. Die Erkennung eines permanent anliegenden Isolationsfehlers, d. h. eines niedrigen Isolationswiderstandes und nicht beispielsweise eines defekten Schutzmantels eines Hochvoltkabels, wird vorteilhafterweise durch ein anderes Gerät erkannt, beispielsweise durch einen Isolationswächter und/oder durch eine Messung einer Hochvolt-Potentialverteilung, welches nicht Bestandteil der hier beschriebenen Schutzvorrichtung 8 und deren Schutzschaltung 9 ist und auch nicht mit dieser in Verbindung steht. Wie erwähnt, ist die hier beschriebene Schutzvorrichtung 8 und deren Schutzschaltung 9 in der Lage, wiederholt in sehr kurzen Abständen und somit auch bei schnell wiederkehrenden Berührungen durch eine Person, auszulösen und somit einen Schutz für die Person sicherzustellen. Ein versehentliches Auslösen, zum Beispiel aufgrund einer EMV-Störung, führt nicht zu weiterführenden Maßnahmen im Fahrzeug 2, wie beispielsweise einem fälschlichen Abschalten des Hochvoltsystems. Durch die autarke Funktion der Schutzvorrichtung 8, insbesondere von deren Schutzschaltung 9, ist eine flexible und einfache Integration in ein bestehendes Hochvoltsystem umsetzbar.

Durch die autarke Funktion werden zudem die Sicherheitsanforderungen an die Schutzvorrichtung 8 und deren Schutzschaltung 9 reduziert, beispielsweise entfällt eine gesicherte Funktion/Kommunikation zu einem weiteren Steuergerät.

Auch bei einem Gleichstromnetz 1 ohne die Gleichstromladestation 5, insbesondere für einen Fahrbetrieb des Fahrzeugs 2, einen Wechselstromladebetrieb sowie für Montage- und Servicearbeiten, ist die Schutzvorrichtung 8 einsetzbar. Einziger Unterschied zum Zustand beim Gleichstromladen ist, dass die Gleichstromladestation 5 fehlt. Als Fehlermechanismus kommen beispielsweise ein defektes Hochvoltkabel oder ein defektes Gehäuse einer Hochvoltelektronik infolge eines Unfalls in Betracht. Auch bei Beschädigungen des Hochvoltsystems während der Montage oder im Service kann die Schutzvorrichtung 8 mit ihrer Schutzschaltung 9 die Ladungsmenge reduzieren.

Die Schutzschaltung 9 zur Reduzierung des Y-Schlages bedingt durch einen Isolationsfehler IF bleibt identisch wie oben beschrieben. Hierfür ist die Schutzvorrichtung 8 mit ihrer Schutzschaltung 9 natürlich im Fahrzeug 2 angeordnet. Die Funktion ist identisch wie zum Fehler in der Isolation während des Gleichstromladens oben beschrieben. Mit dem Erkennen der Verringerung der Spannung zwischen einem der Hochvoltpotentiale HV+, HV- und dem Bezugspotential M wird der jeweilige Schutzkondensator Cs, Cs1, Cs2 hinzugeschaltet und die Gesamtkapazität der Y-Kondensatoren CyF+, CyF-, CyL+, CyL- des betroffenen Hochvoltpotentials HV+, HV- wird entladen. Es kann beispielsweise zudem ein Öffnen der Hauptschütze HS+, HS- der Hochvoltbatterie 6 kommandiert und eine aktive Entladung des X-Kondensators Cx und beider Y-Kondensatoren CyF+, CyF- des Fahrzeugs 2 eingeleitet werden. Die Ladeschütze LS+, LS- sind bereits vorher geöffnet und bleiben auch immer offen.

Figur 6 zeigt die bauteiloptimierte Schutzschaltung 9. Bei der Schutzschaltung 9 zur Reduzierung eines Cy-Schlages ist davon auszugehen, dass nur ein Hochvoltpotential HV+, HV- über den Körperwiderstand R_{K} mit dem Bezugspotential M, beispielsweise der Gehäusemasse, verbunden ist. Wären beide Hochvoltpotentiale HV+, HV- mit dem Bezugspotential M, insbesondere der Gehäusemasse, verbunden, würde dies einem Kurzschluss der Hochvoltbatterie 6 oder Gleichstromladestation 5 gleich kommen, der durch eine Sicherung oder einen Stromsensor mit dadurch gesteuerter Abschaltvorrichtung getrennt werden muss.

Daraus wird deutlich, dass die Schutzschaltung 9 zur Reduzierung eines Cy-Schlages für das Pluspotential HV+ und das Minuspotential HV- nie zur selben Zeit zum Einsatz kommt. Daher können ein einziger Schutzkondensator Cs, Entladewiderstand Re, Schutzwiderstand Rs, Schnellentladewiderstand Rse und Schnellentladeschalter Se für die Absicherung beider Hochvoltpotentiale HV+, HV- verwendet werden, wie in Figur 6 gezeigt. Es sind somit keine zwei Schutzschaltungsteile 9.1, 9.2 erforderlich. Die Spannungsmessungen mittels der beiden Spannungsmessvorrichtungen SV1, SV2 und die beiden Schutzschalter SS1, SS2 für die Zuschaltung der Schutzschaltung 9 müssen weiterhin bestehen bleiben. Figur 6 zeigt eine solche Bauteiloptimierung. Dies ist sinnvoll, wenn der Entladewiderstand Re aufgrund von beispielsweise hohen Betriebsspannungen oder großen Kapazitäten der Y-Kondensatoren CyF+, CyF-, CyL+, CyL- im Fahrzeug 2 und der Gleichstromladestation 5 ebenfalls größere Bauteilwerte annehmen muss.

Figur 6 zeigt zudem eine Ausführungsform der gesamten Schutzvorrichtung 8 mit dieser bauteiloptimierten Schutzschaltung 9, d. h. ohne die beiden Schutzschaltungsteile 9.1, 9.2. Die Schutzvorrichtung 8, insbesondere deren Schutzschaltung 9, ist hier reduziert auf den notwendigen Zusatzaufwand, der im Fahrzeug 2 oder an der Gleichstromladestation 5 zu integrieren ist.

Anschlüsse AHV+, AHV-, AM zum Pluspotential HV+, Minuspotential HV- und Bezugspotential M können sehr klein gehalten werden, da nur im Fehlerfall ein Strom im Millisekundenbereich fließt. Ansonsten sind die Anschlüsse AHV+, AHV-, AM stromfrei und dienen nur zur Spannungsmessung. Daraus folgt, dass eine schnelle Integration der Schutzvorrichtung 8 mit ihrer Schutzschaltung 9 in ein bestehendes Hochvoltsystem mit geringen Änderungen möglich ist. Wenn mehr Planungszeit vorhanden ist, kann diese Funktion selbstverständlich auch in ein bestehendes Gerät integriert werden.

Die Schutzschaltung 9 umfasst somit, wie in Figur 6 gezeigt, eine elektrische Reihenschaltung des elektrischen Schutzkondensators Cs, des elektrischen Schutzwiderstands Rs und des ersten Schutzschalters SS1 zwischen der Pluspotentialleitung HV+L und der Bezugspotentialleitung ML und eine elektrische Reihenschaltung des elektrischen Schutzkondensators Cs, des elektrischen Schutzwiderstands Rs und des zweiten Schutzschalters SS2 zwischen der Minuspotentialleitung HV-L und der Bezugspotentialleitung ML, wobei zum Schutzkondensator Cs und Schutzwiderstand Rs der elektrische Entladewiderstand Re elektrisch parallel geschaltet ist und zum Schutzkondensator Cs oder zum Schutzkondensator Cs und Schutzwiderstand Rs eine elektrische Reihenschaltung aus dem elektrischen Schnellentladewiderstand Rse und dem Schnellentladeschalter Se elektrisch parallel geschaltet ist.

In einem Verfahren zum Betrieb der Schutzvorrichtung 8 wird der erste Schutzschalter SS1 oder der zweite Schutzschalter SS2 bei Eintritt der Auslösekriterien geschlossen und nach einem Aufladen des Schutzkondensators Cs wieder geöffnet und danach der Schnellentladeschalter Se geschlossen und nach einem Entladen des Schutzkondensators Cs wieder geöffnet.

In einer alternativen Ausführungsform umfasst die Schutzschaltung 9, wie in Figur 5 gezeigt, zwei Schutzschaltungsteile 9.1, 9.2. Der erste Schutzschaltungsteil 9.1 umfasst eine elektrische Reihenschaltung des ersten elektrischen Schutzkondensators Cs1, des ersten elektrischen Schutzwiderstands Rs1 und des ersten Schutzschalters SS1 zwischen der Pluspotentialleitung HV+L und der Bezugspotentialleitung ML, wobei zum ersten Schutzkondensator Cs1 und ersten Schutzwiderstand Rs1 ein erster elektrischer Entladewiderstand Re1 elektrisch parallel geschaltet ist und zum ersten Schutzkondensator Cs1 oder zum ersten Schutzkondensator Cs1 und ersten Schutzwiderstand Rs1 eine elektrische Reihenschaltung aus einem ersten elektrischen Schnellentladewiderstand Rse1 und einem ersten Schnellentladeschalter Se1 elektrisch parallel geschaltet ist. Der zweite Schutzschaltungsteil 9.2 umfasst eine elektrische Reihenschaltung eines zweiten elektrischen Schutzkondensators Cs2, eines zweiten elektrischen Schutzwiderstands Rs2 und eines zweiten Schutzschalters SS2 zwischen der Minuspotentialleitung HV-L und der Bezugspotentialleitung ML, wobei zum zweiten Schutzkondensator Cs2 und zweiten Schutzwiderstand Rs2 ein zweiter elektrischer Entladewiderstand Re2 elektrisch parallel geschaltet ist und zum zweiten Schutzkondensator Cs2 oder zum zweiten Schutzkondensator Cs2 und zweiten Schutzwiderstand Rs2 eine elektrische Reihenschaltung aus einem zweiten elektrischen Schnellentladewiderstand Rse2 und einem zweiten Schnellentladeschalter Se2 elektrisch parallel geschaltet ist.

Im Verfahren zum Betrieb der Schutzvorrichtung 8 wird dann entsprechend der erste Schutzschalter SS1 bei Eintritt der Auslösekriterien geschlossen und nach einem Aufladen des ersten Schutzkondensators Cs1 wieder geöffnet und danach der erste Schnellentladeschalter Se1 geschlossen und nach einem Entladen des ersten Schutzkondensators Cs1 wieder geöffnet, und/oder der zweite Schutzschalter SS2 wird bei Eintritt der Auslösekriterien geschlossen und nach einem Aufladen des zweiten Schutzkondensators Cs2 wieder geöffnet und danach der zweite Schnellentladeschalter Se2 geschlossen und nach einem Entladen des zweiten Schutzkondensators Cs2 wieder geöffnet.

Im Folgenden werden vorteilhafte Verwendungsmöglichkeiten der Schutzvorrichtung 8 beschrieben. Bei Fahrzeugen 2 mit einem Hochvoltsystem in der 800 V-Ebene wird es schwierig, die normativ geforderten Grenzwerte der Entladung durch Y-Kondensatoren CyF+, CyF-, CyL+, CyL- einzuhalten. Dies gilt im Besonderen für bereits existente Fahrzeuge 2, die durch bereits belegte Bauräume im Fahrzeug 2 keine Anpassungen im Hochvoltsystem für große Zusatzkomponenten erlauben. Hier bietet sich die beschriebene Lösung an, da sie einfach, kostengünstig und mit einem geringen Bauraumerfordernis im Fahrzeug 2 zu installieren ist.

Des Weiteren werden durch die beschriebene Lösung Vorschriften, insbesondere aus Normen, erfüllt, wodurch eine Zulassung des Fahrzeugs 2 erleichtert oder erst ermöglicht wird. Durch diese Schutzvorrichtung 8 und ihre Schutzschaltung 9 werden mit dem Hinzufügen einer kleinen Elektronik die Grenzwerte erreicht, ohne dass am Hochvoltsystem und dessen Komponenten etwas verändert werden muss.

Der in der LV123 geforderte maximale Energieinhalt von 0,2 J wird bereits bei 632 V durch die Gleichstromladestation 5 überschritten. "Alternative measures", d. h. alternative Maßnahmen, sind somit zwingend erforderlich. Als einzige Lösung wird eine doppelte Isolation momentan diskutiert. Alle gekoppelten Systeme, d. h. Fahrzeug 2 und Gleichstromladestation 5, müssen dann gleichzeitig über eine verstärkte Isolation verfügen, was aktuell nicht sichergestellt werden kann. Durch die Schutzvorrichtung 8 und ihre Schutzschaltung 9 kann die durch den menschlichen Körper MK geströmte Energie jedoch ebenfalls auf einen Wert unterhalb von 0,2 J gehalten werden. Sie stellt somit eine weitere Lösung für "alternative measures" dar.

Die Schutzvorrichtung 8 und ihre Schutzschaltung 9 ermöglichen es, bei einer beschädigten Isolation während des Gleichstromladens, beispielsweise bei einem beschädigten Ladestecker oder Ladekabel 4, den gefährlichen Entladestrom der Y-Kondensatoren CyF+, CyF-, CyL+, CyL- beim Kontakt durch den Menschen zu reduzieren. In allen anderen Fahrzeugzuständen wird ebenfalls bei einer beschädigten Isolation der gefährliche Entladestrom beim Kontakt durch den Menschen reduziert.

Eine verbesserte EMV-Entstörung ist durch eine größere Gestaltung der Y-Kondensatoren CyF+, CyF-, CyL+, CyL- möglich. Ein Verzicht auf die Anforderung der doppelten Isolation des gesamten Hochvoltsystems wird ermöglicht. Dies gilt für Fahrzeug 2 und Gleichstromladestation 5.

Die Schutzvorrichtung 8 mit ihrer Schutzschaltung 9 kann im Fahrzeug 2 und/oder in der Gleichstromladestation 5 angeordnet werden.

### Bezugszeichenliste

- 1: Gleichstromnetz
- 2: Fahrzeug
- 3: Hochvoltbordnetz
- 4: Ladekabel
- 5: Gleichstromladestation
- 6: Hochvoltbatterie
- 7: Batterieenergiequelle
- 8: Schutzvorrichtung
- 9: Schutzschaltung
- 9.1, 9.2: Schutzschaltungsteil
- 12: Spannungsauswerteeinheit
- 13: Ladestationsspannungsquelle

- AHV+, AHV-, AM: Anschluss
- AK+, AK-: Anschlusskontakt
- Cs, Cs1, Cs2: Schutzkondensator
- Cx: X-Kondensator
- CyF+, CyF-: Y-Kondensator Fahrzeug
- CyL+, CyL-: Y-Kondensator Gleichstromladestation
- HS+, HS-: Hauptschütz
- HV+, HV-: Hochvoltpotential
- HV+L, HV-L: Hochvoltpotentialleitung
- IF: Isolationsfehler
- LS+, LS-: Ladeschütz
- M: Bezugspotential
- ML: Bezugspotentialleitung
- MK: menschlicher Körper
- R_{Batt}: Batterieinnenwiderstand
- R, R1, R2: Widerstand
- Re, Re1, Re2: Entladewiderstand
- R_{K}: Körperwiderstand
- R_{LS}: Ladestationinnenwiderstand
- Rs, Rs1, Rs2: Schutzwiderstand
- Rse, Rse1, Rse2: Schnellentladewiderstand
- Se, Se1, Se2: Schnellentladeschalter
- SS1, SS2: Schutzschalter
- SV1, SV2: Spannungsmessvorrichtung

## Patentansprüche

1. Schutzvorrichtung (8) für ein elektrisches Gleichstromnetz (1),
- mit einer ersten Spannungsmessvorrichtung (SV1) zwischen einer Pluspotentialleitung (HV+L) und einer Bezugspotentialleitung (ML) zur Messung einer Spannung zwischen der Pluspotentialleitung (HV+L) und der Bezugspotentialleitung (ML) und
- mit einer zweiten Spannungsmessvorrichtung (SV2) zwischen einer Minuspotentialleitung (HV-L) und der Bezugspotentialleitung (ML) zur Messung einer Spannung zwischen der Minuspotentialleitung (HV-L) und der Bezugspotentialleitung (ML) und,
- mit einer Schutzschaltung (9) zur Reduzierung eines durch Y-Kondensatoren des elektrischen Gleichstromnetzes (1) verursachten elektrischen Schlags,
wobei die Schutzschaltung (9) einen ersten Schutzschalter (SS1) zwischen der Pluspotentialleitung (HV+L) und der Bezugspotentialleitung (ML) und einen zweiten Schutzschalter (SS2) zwischen der Minuspotentialleitung (HV-L) und der Bezugspotentialleitung (ML) umfasst,
- wobei mehrere Auslösekriterien vorgegeben sind und
der erste Schutzschalter (SS1) und/oder der zweite Schutzschalter (SS2) ausschließlich bei einem mittels der ersten Spannungsmessvorrichtung (SV1) und/oder mittels der zweiten Spannungsmessvorrichtung (SV2) ermittelten Eintritt aller vorgegebenen Auslösekriterien zum Schließen ansteuerbar ist,
**dadurch gekennzeichnet, dass**
die Auslösekriterien umfassen:
- eine Spannungsabweichung einer aktuell zwischen der Pluspotentialleitung (HV+L) und der Bezugspotentialleitung (ML) anliegenden Spannung und einer zwischen der Minuspotentialleitung (HV-L) und der Bezugspotentialleitung (ML) anliegenden Spannung von einem zeitlich zuvor ermittelten Spannungswert,
- eine Spannungsänderungen der zwischen der Pluspotentialleitung (HV+L) und der Bezugspotentialleitung (ML) anliegenden Spannung und der zwischen der Minuspotentialleitung (HV-L) und der Bezugspotentialleitung (ML) anliegenden Spannung,
- ein entgegengesetztes Vorzeichen der zwischen der Pluspotentialleitung (HV+L) und der Bezugspotentialleitung (ML) anliegenden Spannung und der zwischen der Minuspotentialleitung (HV-L) und der Bezugspotentialleitung (ML) anliegenden Spannung, und
- ein Nichtvorliegen einer zyklischen Wiederholung der anderen Auslösekriterien, wobei der erste Schutzschalter (SS1) und/oder der zweite Schutzschalter (SS2) ausschließlich dann ansteuerbar sind/ist, wenn
- die Spannungsabweichung der aktuell zwischen der Pluspotentialleitung (HV+L) und der Bezugspotentialleitung (ML) anliegenden Spannung und der zwischen der Minuspotentialleitung (HV-L) und der Bezugspotentialleitung (ML) anliegenden Spannung von dem zeitlich zuvor ermittelten Spannungswert einen vorgegebenen Grenzwert überschreitet, und
- die Spannungsänderungen der zwischen der Pluspotentialleitung (HV+L) und der Bezugspotentialleitung (ML) anliegenden Spannung und der zwischen der Minuspotentialleitung (HV-L) und der Bezugspotentialleitung (ML) anliegenden Spannung einen vorgegebenen Grenzwert überschreitet, und
- das entgegengesetzte Vorzeichen der zwischen der Pluspotentialleitung (HV+L) und der Bezugspotentialleitung (ML) anliegenden Spannung und der zwischen der Minuspotentialleitung (HV-L) und der Bezugspotentialleitung (ML) anliegenden Spannung vorliegt, und
wenn zusätzlich das Nichtvorliegen einer zyklischen Wiederholung der anderen Auslösekriterien ermittelt ist.

2. Schutzvorrichtung (8) nach Anspruch 1,
**dadurch gekennzeichnet, dass**
eine analoge und/oder digitale Auswertung der mittels der ersten Spannungsmessvorrichtung (SV1) und/oder mittels der zweiten Spannungsmessvorrichtung (SV2) ermittelten Spannung vorgesehen ist.

3. Schutzvorrichtung (8) nach Anspruch 1 oder 2,
**dadurch gekennzeichnet, dass**
eine mit den Spannungsmessvorrichtungen (SV1, SV2) und den Schutzschaltern (SS1, SS2) gekoppelte gemeinsame Spannungsauswerteeinheit (12) zur Auswertung der von der ersten Spannungsmessvorrichtung (SV1) ermittelten Spannung und der von der zweiten Spannungsmessvorrichtung (SV2) ermittelten Spannung und zur Ansteuerung des ersten Schutzschalters (SS1) und/oder des zweiten Schutzschalters (SS2) ausschließlich bei dem mittels der ersten Spannungsmessvorrichtung (SV1) und/oder mittels der zweiten Spannungsmessvorrichtung (SV2) ermittelten Eintritt aller vorgegebenen Auslösekriterien vorgesehen ist.

4. Schutzvorrichtung (8) nach einem der vorhergehenden Ansprüche,
**dadurch gekennzeichnet, dass**
der jeweilige Schutzschalter (SS1, SS2) als ein Halbleiterschalter ausgebildet ist.

5. Bordnetz (3), insbesondere Hochvoltbordnetz (3), für ein Fahrzeug (2), umfassend eine Schutzvorrichtung (8) nach einem der vorhergehenden Ansprüche.

6. Fahrzeug (2), insbesondere Elektrofahrzeug oder Hybridfahrzeug, umfassend ein Bordnetz (3) nach Anspruch 5.

7. Gleichstromladestation (5), insbesondere Hochvoltgleichstromladestation, umfassend eine Schutzvorrichtung (8) nach einem der Ansprüche 1 bis 4.

## Claims

1. Safety device (8) for an electric DC grid (1), comprising
- a first voltage measuring device (SV1) between a positive potential line (HV+L) and a reference potential line (ML) for measuring a voltage between the positive potential line (HV+L) and the reference potential line (ML), and
- a second voltage measuring device (SV2) between a negative potential line (HV-L) and the reference potential line (ML) for measuring a voltage between the negative potential line (HV-L) and the reference potential line (ML), and
- a protective circuit (9) for reducing an electric shock caused by Y capacitors of the electric DC grid (1),
wherein the protective circuit (9) comprises a first circuit breaker (SS1) between the positive potential line (HV+L) and the reference potential line (ML), and a second circuit breaker (SS2) between the negative potential line (HV-L) and the reference potential line (ML),
- wherein a plurality of triggering criteria are specified and
the first circuit breaker (SS1) and/or the second circuit breaker (SS2) can be actuated so as to close exclusively in the event of all predefined triggering criteria being met, as determined by means of the first voltage measuring device (SV1) and/or by means of the second voltage measuring device (SV2),
**characterized in that**
the triggering criteria include:
- a voltage deviation of a voltage currently applied between the positive potential line (HV+L) and the reference potential line (ML) and a voltage applied between the negative potential line (HV-L) and the reference potential line (ML) from a previously determined voltage value,
- a voltage change in the voltage applied between the positive potential line (HV+L) and the reference potential line (ML) and the voltage applied between the negative potential line (HV-L) and the reference potential line (ML),
- an opposite sign of the voltage applied between the positive potential line (HV+L) and the reference potential line (ML) and the voltage applied between the negative potential line (HV-L) and the reference potential line (ML), and
- a lack of cyclical repetition of the other triggering criteria, the first circuit breaker (SS1) and/or the second circuit breaker (SS2) only being actuatable if
- the voltage deviation of the voltage currently applied between the positive potential line (HV+L) and the reference potential line (ML) and the voltage applied between the negative potential line (HV-L) and the reference potential line (ML) from the previously determined voltage value exceeds a predefined limit value, and
- the voltage change of the voltage applied between the positive potential line (HV+L) and the reference potential line (ML) and the voltage applied between the negative potential line (HV-L) and the reference potential line (ML) exceeds a predefined limit value, and
- the opposite sign of the voltage applied between the positive potential line (HV+L) and the reference potential line (ML) and the voltage applied between the negative potential line (HV-L) and the reference potential line (ML) is present, and
if, in addition, the lack of cyclical repetition of the other triggering criteria is determined.

2. Safety device (8) according to claim 1,
**characterized in that**
an analog and/or digital evaluation of the voltage determined by means of the first voltage measuring device (SV1) and/or by means of the second voltage measuring device (SV2) is provided.

3. Safety device (8) according to either claim 1 or claim 2,
**characterized in that**
a common voltage evaluation unit (12) coupled to the voltage measuring devices (SV1, SV2) and the circuit breakers (SS1, SS2) is provided for evaluating the voltage determined by the first voltage measuring device (SV1) and the voltage determined by the second voltage measuring device (SV2) and for actuating the first circuit breaker (SS1) and/or the second circuit breaker (SS2) exclusively in the event of all predefined triggering criteria being met, as determined by means of the first voltage measuring device (SV1) and/or by means of the second voltage measuring device (SV2).

4. Safety device (8) according to any of the preceding claims,
**characterized in that**
the relevant circuit breaker (SS1, SS2) is designed as a semiconductor switch.

5. On-board network (3), in particular a high-voltage on-board network (3), for a vehicle (2), comprising a safety device (8) according to any of the preceding claims.

6. Vehicle (2), in particular an electric vehicle or hybrid vehicle, comprising an on-board network (3) according to claim 5.

7. DC charging station (5), in particular a high-voltage DC charging station, comprising a safety device (8) according to any of claims 1 to 4.

## Revendications

1. Dispositif de protection (8) pour un réseau électrique à courant continu (1),
- comportant un premier dispositif de mesure de tension (SV1) entre une ligne de potentiel positif (HV+L) et une ligne de potentiel de référence (ML) pour la mesure d'une tension entre la ligne de potentiel positif (HV+L) et la ligne de potentiel de référence (ML) et
- comportant un second dispositif de mesure de tension (SV2) entre une ligne de potentiel négatif (HV-L) et la ligne de potentiel de référence (ML) pour la mesure d'une tension entre la ligne de potentiel négatif (HV-L) et la ligne de potentiel de référence (ML) et,
- comportant un circuit de protection (9) pour la réduction d'un choc électrique provoqué par des condensateurs Y du réseau électrique à courant continu (1),
dans lequel le circuit de protection (9) comprend un premier disjoncteur (SS1) entre la ligne de potentiel positif (HV+L) et la ligne de potentiel de référence (ML) et un second disjoncteur (SS2) entre la ligne de potentiel négatif (HV-L) et la ligne de potentiel de référence (ML),
- dans lequel plusieurs critères de déclenchement sont prédéfinis et
le premier disjoncteur (SS1) et/ou le second disjoncteur (SS2) peuvent être commandés pour la fermeture exclusivement à une entrée de tous les critères de déclenchement prédéfinis, déterminée à l'aide du premier dispositif de mesure de tension (SV1) et/ou à l'aide du second dispositif de mesure de tension (SV2),
**caractérisé en ce que**
les critères de déclenchement comprennent :
- un écart de tension d'une tension actuellement présente entre la ligne de potentiel positif (HV+L) et la ligne de potentiel de référence (ML) et d'une tension présente entre la ligne de potentiel négatif (HV-L) et la ligne de potentiel de référence (ML) par rapport à une valeur de tension déterminée auparavant dans le temps,
- une variation de tension de la tension présente entre la ligne de potentiel positif (HV+L) et la ligne de potentiel de référence (ML) et de la tension présente entre la ligne de potentiel négatif (HV-L) et la ligne de potentiel de référence (ML),
- un signe opposé de la tension présente entre la ligne de potentiel positif (HV+L) et la ligne de potentiel de référence (ML) et de la tension présente entre la ligne de potentiel négatif (HV-L) et la ligne de potentiel de référence (ML), et
- une non-présence d'une répétition cyclique des autres critères de déclenchement, dans lequel le premier disjoncteur (SS1) et/ou le second disjoncteur (SS2) peuvent être commandés exclusivement lorsque
- l'écart de tension entre la tension actuellement présente entre la ligne de potentiel positif (HV+L) et la ligne de potentiel de référence (ML) et la tension présente entre la ligne de potentiel négatif (HV-L) et la ligne de potentiel de référence (ML) par rapport à la valeur de tension déterminée auparavant dans le temps dépasse une valeur limite prédéfinie, et
- la variation de tension de la tension présente entre la ligne de potentiel positif (HV+L) et la ligne de potentiel de référence (ML) et de la tension présente entre la ligne de potentiel négatif (HV-L) et la ligne de potentiel de référence (ML) dépasse une valeur limite prédéfinie, et
- le signe opposé de la tension présente entre la ligne de potentiel positif (HV+L) et la ligne de potentiel de référence (ML) et de la tension présente entre la ligne de potentiel négatif (HV-L) et la ligne de potentiel de référence (ML) est présent, et
lorsque, en outre, la non-présence de répétition cyclique des autres critères de déclenchement est déterminée.

2. Dispositif de protection (8) selon la revendication 1,
**caractérisé en ce**
**qu**'une évaluation analogique et/ou numérique de la tension déterminée à l'aide du premier dispositif de mesure de tension (SV1) et/ou à l'aide du second dispositif de mesure de tension (SV2) est prévue.

3. Dispositif de protection (8) selon la revendication 1 ou 2,
**caractérisé en ce**
**qu**'une unité d'évaluation de tension (12) commune couplée aux dispositifs de mesure de tension (SV1, SV2) et aux disjoncteurs (SS1, SS2) est prévue pour l'évaluation de la tension déterminée par le premier dispositif de mesure de tension (SV1) et de la tension déterminée par le second dispositif de mesure de tension (SV2) et pour la commande du premier disjoncteur (SS1) et/ou du second disjoncteur (SS2) exclusivement à l'entrée de tous les critères de déclenchement prédéfinis, déterminée à l'aide du premier dispositif de mesure de tension (SV1) et/ou à l'aide du second dispositif de mesure de tension (SV2).

4. Dispositif de protection (8) selon l'une des revendications précédentes,
**caractérisé en ce que**
le disjoncteur (SS1, SS2) respectif est conçu sous la forme d'un commutateur à semi-conducteurs.

5. Réseau de bord (3), en particulier réseau de bord haute tension (3), pour un véhicule (2), comprenant un dispositif de protection (8) selon l'une des revendications précédentes.

6. Véhicule (2), en particulier véhicule électrique ou véhicule hybride, comprenant un réseau de bord (3) selon la revendication 5.

7. Station de charge à courant continu (5), en particulier station de charge à courant continu à haute tension, comprenant un dispositif de protection (8) selon l'une des revendications 1 à 4.
